(19) Europäisches Patentamt
European Patent Office
Office européen des brevets

(11) EP 2 814 108 A1

(12) **EUROPEAN PATENT APPLICATION**
published in accordance with Art. 153(4) EPC

(43) Date of publication:
**17.12.2014 Bulletin 2014/51**

(21) Application number: **13746872.4**

(22) Date of filing: **05.02.2013**

(51) Int Cl.:
***H01M 14/00*** *(2006.01)* ***C09B 57/10*** *(2006.01)*
***H01L 31/04*** *(2014.01)* ***C07F 15/00*** *(2006.01)*

(86) International application number:
**PCT/JP2013/052584**

(87) International publication number:
**WO 2013/118709 (15.08.2013 Gazette 2013/33)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **08.02.2012 JP 2012025146**

(71) Applicant: **FUJIFILM Corporation**
**Tokyo 106-8620 (JP)**

(72) Inventor: **NOMURA, Kimiatsu**
**Ashigarakami-gun**
**Kanagawa 258-8577 (JP)**

(74) Representative: **Hoffmann Eitle**
**Patent- und Rechtsanwälte PartmbB**
**Arabellastraße 30**
**81925 München (DE)**

(54) **PHOTOELECTRIC CONVERSION ELEMENT, METHOD FOR MANUFACTURING PHOTOELECTRIC CONVERSION ELEMENT, AND DYE-SENSITIZED SOLAR CELL USING PHOTOELECTRIC CONVERSION ELEMENT**

(57) A method of producing a photoelectric conversion element, which includes: a step of a treatment under specific conditions, when a dye-adsorbing liquid containing a sensitizing dye in a solvent is brought into contact with semiconductor fine-particles, to form the dye-adsorbed electrode having the sensitizing dye adsorbed on the semiconductor fine-particles.

{Fig. 1}

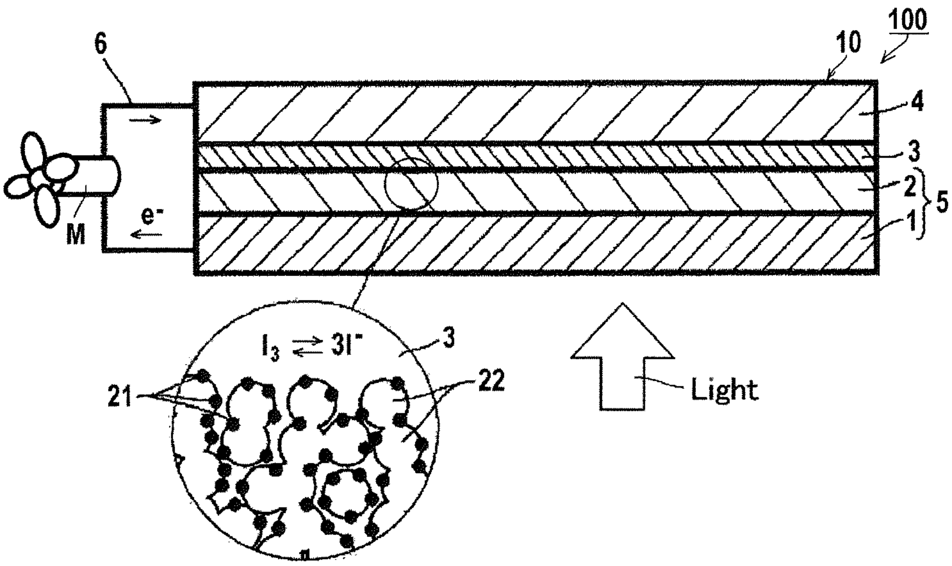


EP 2 814 108 A1

## Description

### TECHNICAL FIELD

The present invention relates to a photoelectric conversion element and a producing method thereof, and a dye-sensitized solar cell using the same.

### BACKGROUND ART

As solar cells that are used for power generation, solar cells composed of various inorganic materials, such as silicon, cadmium telluride, or copper indium selenide, are main targets in research and development, and a part thereof is put in practical use. However, in order to widely expand use of these solar cells to applications, such as a household power supply, these solar cells have problems, such as difficulty in manufacturing the cells at a low cost or securing a raw material sufficiently, and also a long energy payback time. These problems are required to be overcome. On the other hand, many proposals have been made for dye-sensitized solar cells produced by using organic materials, for the purpose of increasing an area of a light-condensing part and providing the cells at a low price. However, these kinds of solar cells generally had a lower conversion efficiency and a poor durability in many cases, as compared to the solar cells produced by using the inorganic materials.

In order to improve the performance of such dye-sensitized solar cells, ruthenium metal complexes with modified ligands or the like, have been developed, as the sensitizing dyes to be used in photoelectric conversion elements (Patent Literatures 1 and 2). Furthermore, co-adsorbents having steroid skeletons or the like, have been proposed (see Patent Literatures 3 to 5).

### CITATION LIST

#### Patent Literatures

Patent Literature 1: Japanese Patent No. 4576494
Patent Literature 2: JP-A-2001-291534 ("JP-A" means unexamined published Japanese patent application)
Patent Literature 3: JP-A-2010-135184
Patent Literature 4: JP-A-2009-132922
Patent Literature 5: JP-A-2008-311127

### SUMMARY OF THE INVENTION

### TECHNICAL PROBLEM

Meanwhile, a dye-sensitized solar cell generates electric power, when electrons are injected from an excited state of a dye adsorbed on oxide semiconductor fine-particles into the oxide semiconductor fine-particles, and the thus-generated dye cation radicals oxidize a redox material in an electrolyte liquid. Therefore, it is conceivable that if cation radicals of a dye serve as cation trap, reduction to the redox material does not proceed smoothly, and when electrons on the oxide semiconductor fine-particles are injected into the cation radicals, this brings about lowering of battery performance.

In view of the current status of the conventional art technologies as described above and the recognition of the problems by the inventor of the present invention, in order to provide an improvement from the viewpoints described above, the present invention is contemplated for providing: a photoelectric conversion element, in which a balance between high photoelectric conversion efficiency and high durability (particularly, durability at a high temperature) is achieved at a high level, and in which fluctuation of the elements is suppressed; a method of producing the photoelectric conversion element; and a dye-sensitized solar cell using this photoelectric conversion element.

### SOLUTION TO PROBLEM

The inventor of the present invention, having studied keenly on a method of producing a photoelectric conversion element which inhibits formation of a cation trap, has succeeded in suppressing the formation of the trap, by investigating the conditions for preparing a dye-adsorbing liquid and the conditions for drying the solvent. As a result, I found that, in addition to improvement of the performance of the element, fluctuation of the element's performance can also be suppressed, by making the adsorbed state of the dye uniform. In regard to the suppression/prevention of the cation trap, I confirm that the dye-adsorbed electrode that has been subjected to the above-described improvement, substantially does not exhibit any peak in measurement of a thermally-stimulated current. That is, the tasks of the present invention can be achieved by the following means.

[1] A method of producing a photoelectric conversion element,
the photoelectric conversion element having:

an electrically-conductive support having a substrate and a transparent electrode;
a photoconductor layer having: a metal complex sensitizing dye having an adsorbing group; and semiconductor fine-particles;
an electrolyte layer having an electrolyte; and
a counter electrode,
wherein, when a dye-adsorbing liquid containing the sensitizing dye in a solvent is brought into contact with the semiconductor fine-particles, to form a dye-adsorbed electrode having the sensitizing dye adsorbed on the semiconductor fine-particles, a treatment is carried out at least under any one of conditions A, B, and C:

[A: In solvent drying after dye adsorption, a heat treatment is carried out at a temperature of 50 to 200°C.]
[B: In solvent drying after dye adsorption, drying is carried out at a pressure of 50,000 to $10^{-3}$ Pa.]
[C: The sensitizing dye is contained in the dye-adsorbing liquid in an amount of 0.001 to 0.1 % by mass, and the amount of water is kept below 0.1% by mass.].

[2] The method of producing a photoelectric conversion element described in item [1], wherein the conditions A and C are applied to in combination, the conditions B and C are applied to in combination, or the conditions A, B, and C are applied to in combination.
[3] The method of producing a photoelectric conversion element described in item [1] or [2], wherein the solvent drying time period for the conditions A and B is set to 5 to 30 minutes.
[4] The method of producing a photoelectric conversion element described in any one of items [1] to [3], wherein the solvent of the dye-adsorbing liquid is an organic solvent selected from the group consisting of an aliphatic alcohol having 1 to 6 carbon atoms in total, an aliphatic amide having 2 to 6 carbon atoms in total, and a combination thereof.
[5] The method of producing a photoelectric conversion element described in any one of items [1] to [4], wherein the sensitizing dye contains at least a dye represented by formula (I):

$$ML^1_{m1}L^2_{m2}X_{mX}\cdot CI \qquad (I)$$

wherein, in formula (I), M represents a metal atom; $L^1$ represents a ligand represented by formula (L1); $L^2$ represents a ligand represented by formula (L2); X represents a monodentate ligand; ml is 1 or 2; m2 is an integer of 0 or 1; mX is an integer of 0 to 3; and CI represents a counter ion, in the case where the counter ion is necessary to neutralize a charge in formula (I);

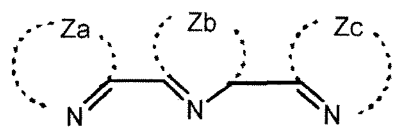
: (L1)

wherein, in formula (L1), Za, Zb, and Zc each independently represent a group of atoms for forming a 5- or 6-membered ring; and at least one ring formed by Za, Zb, or Zc has an acidic group;

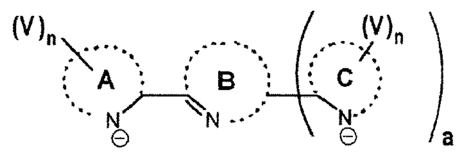
: (L2)

wherein, in formula (L2), A, B, and C each independently represent a nitrogen-containing aromatic ring having a 5-membered or higher-membered ring; a is 0 or 1; V represents a substituent; and n represents an integer of 0 or more.
[6] The method of producing a photoelectric conversion element described in any one of items [1] to [4], wherein

the sensitizing dye contains at least a dye represented by formula (II):

$$ML^3_{m3}L^4_{m4}Y_{mY}\cdot CI \qquad (II)$$

wherein, in formula (II), M represents a metal atom; $L^3$ represents a bidentate ligand represented by formula (L3); $L^4$ represents a bidentate or terdentate ligand represented by formula (L4); Y represents a monodentate or bidentate ligand; m3 represents an integer of 0 to 3; m4 represents an integer of 1 to 3; mY represents an integer of 0 to 2; and CI represents a counter ion, in the case where the counter ion is necessary to neutralize a charge in formula (II);

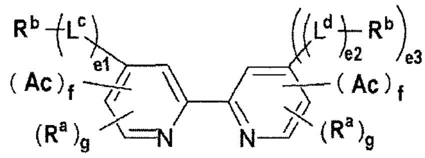
: (L3)

wherein, in formula (L3), Ac represents an acidic group; $R^a$ represents a substituent; $R^b$ represents an alkyl group or an aromatic cyclic group; e1 and e2 each independently represent an integer of 0 to 5; $L^c$ and $L^d$ each independently represent a conjugated chain; e3 is 0 or 1; f represents an integer of 0 to 3; g represents an integer of 0 to 3; and

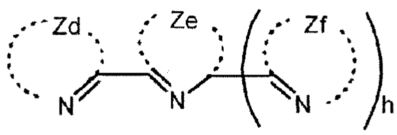
: (L4)

wherein, in formula (L4), Zd, Ze, and Zf each independently represent a group of atoms for forming a 5- or 6-membered ring; h is 0 or 1; and at least one ring formed by Zd, Ze, or Zf has an acidic group.

[7] The method of producing a photoelectric conversion element described in item [5] or [6], wherein M in the sensitizing dye is Ru, Fe, Os, Cu, W, Cr, Mo, Ni, Pd, Pt, Co, Ir, Rh, Re, Mn, or Zn.

[8] A photoelectric conversion element, having:

an electrically-conductive support having a substrate and a transparent electrode;
a photoconductor layer having: a metal complex sensitizing dye having an adsorbing group; and semiconductor fine-particles;
a photoconductor having an electrolyte; and
a counter electrode,
wherein a dye-adsorbed electrode has no peak current value at 150K or more, in measurement of a thermally-stimulated current; and
wherein the peak electric current value at 100 to 120K is 0.3 pA/$cm^2$ or less.

[9] The photoelectric conversion element described in item [8], wherein a redox agent constituting the electrolyte is a cobalt complex.

[10] The photoelectric conversion element described in item [8] or [9], wherein the sensitizing dye contains at least a dye represented by formula (I):

$$ML^1_{m1}L^2_{m2}X_{mX}\cdot CI \qquad (I)$$

wherein, in formula (I), M represents a metal atom; $L^1$ represents a ligand represented by formula (L1); $L^2$ represents a ligand represented by formula (L2); X represents a monodentate ligand; ml is 1 or 2; m2 is an integer of 0 or 1; mX is an integer of 0 to 3; and CI represents a counter ion in the case where the counter ion is necessary to neutralize a charge in formula (I);

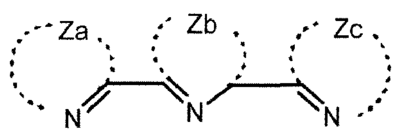
: (L1)

wherein, in formula (L1), Za, Zb, and Zc each independently represent a group of atoms for forming a 5- or 6-membered ring; and at least one ring formed by Za, Zb, or Zc has an acidic group; and

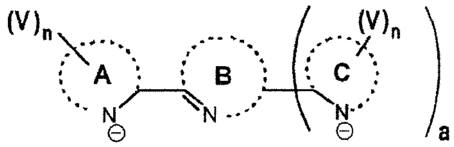

: (L2)

wherein, in formula (L2), A, B, and C each independently represent a nitrogen-containing aromatic ring having a 5-membered or higher-membered ring; a represents 0 or 1; V represents a substituent; and n represents an integer of 0 or more.

[11] The photoelectric conversion element described in item [8] or [9], wherein the sensitizing dye contains at least a dye represented by formula (II):

$$ML^3_{m3}L^4_{m4}Y_{mY}\cdot CI \qquad (II)$$

wherein, in formula (II), M represents a metal atom; $L^3$ represents a bidentate ligand represented by formula (L3); $L^4$ represents a bidentate or terdentate ligand represented by formula (L4); Y represents a monodentate or bidentate ligand; m3 represents an integer of 0 to 3; m4 represents an integer of 1 to 3; mY represents an integer of 0 to 2; and CI represents a counter ion in the case where the counter ion is necessary to neutralize a charge in formula (II);

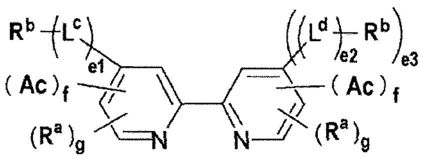

: (L3)

wherein, in formula (L3), Ac represents an acidic group; $R^a$ represents a substituent; $R^b$ represents an alkyl group or an aromatic cyclic group; e1 and e2 each independently represent an integer of 0 to 5; $L^c$ and $L^d$ each independently represent a conjugated chain; e3 represents 0 or 1; f represents an integer of 0 to 3; and g represents an integer of 0 to 3; and

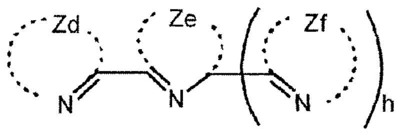

: (L4)

wherein, in formula (L4), Zd, Ze, and Zf each independently represent a group of atoms capable of forming a 5- or 6-membered ring; h represents 0 or 1; and at least one ring formed by Zd, Ze, or Zf has an acidic group.

[12] A dye-sensitized solar cell, comprising the photoelectric conversion element described in any one of items [8] to [11].

In the present specification, the aromatic ring is used in a meaning including an aromatic ring and a hetero ring (an aliphatic hetero ring and an aromatic hetero ring), and it may be a single ring or a multi ring. With respect to the carbon-carbon double bond, in the case where the E configuration and the Z configuration exist in the molecule, it may be either one of the two configurations. When a plurality of substituents, linking groups, ligands, or the like (hereinafter, referred to as "substituent(s) or the like") represented by specific symbols are described herein, or a plurality of substituents or the like are defined all together or alternatively, each of the substituents or the like may be the same as or different from one another. This is also applied to the definition of the number of substituents or the like. When a plurality of substituents or the like are close to one another, they may be linked to one another or may be ring-fused, to form a ring.

ADVANTAGEOUS EFFECTS OF INVENTION

The present invention can provide: a photoelectric conversion element, in which a balance between high photoelectric conversion efficiency and high durability (particularly, durability at a high temperature) is achieved at a high

level, and in which a fluctuation among the products has been suppressed; a method of producing the photoelectric conversion element; and a dye-sensitized solar cell using the photoelectric conversion element.

Other and further features and advantages of the invention will appear more fully from the following description, appropriately referring to the accompanying drawings.

BRIEF DESCRIPTION OF THE DRAWINGS

{Fig. 1}
Fig. 1 is a cross-sectional view schematically showing an exemplary embodiment of the photoelectric conversion element according to the present invention.
{Fig. 2}
Fig. 2 is a cross-sectional view schematically showing the dye-sensitized solar cell produced in Example 1.

MODE FOR CARRYING OUT THE INVENTION

The method of producing a photoelectric conversion element of the present invention is characterized in that when a dye-adsorbing liquid containing a sensitizing dye in a solvent is brought into contact with semiconductor fine-particles, to form a dye-adsorbed electrode having the sensitizing dye adsorbed to the semiconductor fine-particles, the treatment is carried out under any one of A to C:

[A: In solvent drying after dye adsorption, a heat treatment is carried out at a temperature of 50 to 200°C.]
[B: In solvent drying after dye adsorption, drying is carried out at a pressure of 50,000 to $10^{-3}$ Pa.]
[C: The sensitizing dye is contained in the dye-adsorbing liquid in an amount of 0.001 to 0.1% by mass, and the amount of water is kept below 0.1% by mass.].

Hereinafter, preferred embodiments of the present invention including the details of the respective conditions described above, will be described.

[Dye-adsorbing liquid]

The dye-adsorbing liquid that can be used in this embodiment contains at least a sensitizing dye in a particular organic solvent. There are no particular limitations on the kind of the organic solvent, but preferred examples include an alcohol (particularly, an aliphatic alcohol having 1 to 6 carbon atoms in total), an amide (particularly, an aliphatic amide having 2 to 6 carbon atoms in total), and combinations thereof, and particularly preferred examples include methanol, t-butanol, ethanol, 2-propanol, N,N-dimethylacetamide, N,N-dimethylformamide, dimethylimidazolidinone, and combinations thereof. The concentration of the sensitizing dye is not particularly limited, but it is preferable, as defined in the condition C, to contain the sensitizing dye in the dye-adsorbing liquid in an amount of 0.001 to 0.1% by mass, and more preferably 0.01 to 0.05% by mass. When the concentration of the sensitizing dye is adjusted to a value more than or equal to the lower limit, it is preferable because the time period of adsorption can be shortened, and a large number of adsorbed electrodes can be fabricated in the same vessel. On the other hand, when the concentration is adjusted to a value less than or equal to the upper limit, it is preferable because lowering of the element performance caused by dye aggregation is suppressed, and fluctuation in the element performance can be reduced.

In regard to the dye-adsorbing liquid, it is preferable that incorporation of water be suppressed, and the concentration of water is preferably kept less than 0.1% by mass, and more preferably kept less than 0.05% by mass (the condition C). When this concentration is adjusted to a value less than or equal to the upper limit, the water content of the dye-adsorbed electrode is lowered, and lowering in the resultant element performance can be suppressed. On the other hand, it is practical that a very small amount of water is contained, and the lower limit value is preferably 0.005% or more. When water is contained at a concentration higher than or equal to this concentration, the cost pressure can be reduced while deterioration of the element performance is suppressed, thereby to make industrial production possible.

In this embodiment, typically, a sensitizing dye can be adsorbed to the surface of semiconductor fine-particles, by immersing, in the dye-adsorbing liquid, an electrode precursor of semiconductor fine-particles that are fixed to a substrate and a transparent electrode, or by applying the dye-adsorbing liquid on the electrode precursor. Then, in the condition A, a heat treatment is carried out at a temperature of 50 to 200°C, and this temperature is preferably a temperature of 75 to 175°C, and more preferably a temperature of 80 to 150°C. On the other hand, in the condition B, drying is carried out at a pressure of 50,000 to $10^{-3}$ Pa, and it is more preferable to perform drying at a pressure of 1,000 to 1 Pa, and it is particularly preferable to perform drying at a pressure of 100 to 10 Pa. The effects that are expected

from both of the two conditions are similar, and the effects are to make the adsorbed state of the sensitizing dye on the surface of the semiconductor fine-particles into a characteristic state, and to obtain a state in which a cation trap of the dye is not likely to be generated. This is understood different in terms of action from annealing, which simply fixes an adsorbed state, and it is conceivable that speeding up of drying leads to a remarkable effect of lowering the proportion of the state in which dye molecules are aggregated.

In the present invention, it is preferable to set the solvent drying time period for the conditions A and B to 5 to 30 minutes. When this time period is adjusted to a value more than or equal to the lower limit, the solvent and the like can be sufficiently evaporated, and the dye adsorption state can be stabilized, which is preferable. On the other hand, when the drying time period is adjusted to a value less than or equal to the upper limit, the time period required for the process can be shortened, and cost can be reduced, which is preferable.

In the present invention, it is preferable: to apply the conditions A and C in combination; to apply the conditions B and C in combination; or to apply the conditions A, B, and C in combination. According to any of those, improvement of the adsorbed state of the sensitizing dye on the surface of the semiconductor fine-particle can be induced as a synergistic effect, and a highly excellent effect can be obtained.

The dye-adsorbed electrode of this embodiment has no peak current value observed at 150 K or more, as determined by measurement of the thermally stimulated current, and the peak current value at 100 to 120 K is 0.3 $pA/cm^2$ or less according to the usual fabrication method. In the present invention, attention was paid to the relationship between this parameter in the dye-adsorbed electrode and the element performance, and the production conditions described above were finally derived. This dye that does not exhibit any particular peak in measurement of the thermally stimulated current, means that a charge trap is not formed in the adsorbed electrode, and it is conceivable that this leads to the avoidance of occurrence of unprepared association. In other words, a dye exhibiting the above peak tends to cause association in the photoelectric conversion element, and generation of a cation trap is also associated, thereby that reduction to a redox material is not smoothly carried out. As a result, it is conceivable that, when electrons on the oxide semiconductor fine-particles are injected to cation radicals, this brings about lowering of the cell performance. When the dye-adsorbed electrode obtained by the production method of the present invention, or a photoelectric conversion element equipped with this dye-adsorbed electrode is used, this problem is solved or improved, and thus satisfactory element performance is exhibited. In regard to the details of measurement of the thermally stimulated current (TSC), reference can be made to Japanese Journal of Applied Physics, Vol. 47, No. 1, 2008, p.505.

[Sensitizing dye]

In the present invention, the sensitizing dye, to which any of the conditions A to C is applied, is limited to a metal complex dye, and it is particularly preferable that the sensitizing dye be any one of formulas (I) and (II). When this sensitizing dye is elected to use, the cation trap suppressing effect described above is exhibited particularly remarkably. Hereinafter, the details of such a sensitizing dye will be described more specifically.

(Dye represented by formula (I))

$$ML^1_{m1}L^2_{m2}X_{mX}\cdot Cl \qquad (I)$$

•M

M represents a metal atom. M is preferably a metal that is capable of tetracoordination or hexacoordination; more preferably Ru, Fe, Os, Cu, W, Cr, Mo, Ni, Pd, Pt, Co, Ir, Rh, Re, Mn, or Zn; particularly preferably Ru, Os, Zn, or Cu; and most preferably Ru.

• $L^1$

$L^1$ is represented by formula (L1).

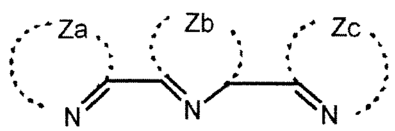

: (L1)

• Za, Zb, and Zc

In formula (L1), Za, Zb, and Zc each independently represent a group of non-metallic atoms for forming a 5-

or 6-membered ring. At least one ring formed by Za, Zb, and Zc has an acidic group Ac.

• Ac

In the present invention, the acidic group means a substituent having a dissociable proton, and examples thereof include a carboxyl group, a phosphonyl group, a phosphoryl group, a sulfo group, a boric acid group, or a group having any one of these groups. Among these, a carboxyl group and a group having a carboxyl group are preferred. Further, the acidic group may be in a dissociation form due to release of a proton, or may be a salt thereof. The acidic group may be a group to which an acidic group binds through a linking group, and preferable examples thereof include a carboxy vinylene group, a dicarboxy vinylene group, a cyanocarboxy vinylene group, and a carboxy phenyl group. These acidic groups and a preferable range thereof herein described may be sometimes referred to as acidic group Ac. Examples of the linking group include an alkylene group having 1 to 4 carbon atoms, an alkenylene group having 2 to 4 carbon atoms, an alkynylene group having 2 to 4 carbon atoms, a carbonyl group, and a carbonyloxy group. The acidic group Ac can function as an adsorbing group that adsorbs to the semiconductor surface.

With respect to Za, Zb, and Zc, the formed 5- or 6-membered ring may be substituted or unsubstituted, and may be a single ring or a condensed ring. Each of Za, Zb, and Zc is preferably composed of at least one of a carbon atom, hydrogen atom, a nitrogen atom, an oxygen atom, a sulfur atom, a phosphorus atom, and a halogen atom, and more preferably forms an aromatic ring. In the case of the 5-membered ring, an imidazole ring, an oxazole ring, a thiazole ring, or a triazole ring is preferably formed. In the case of the 6-membered ring, a pyridine ring, a pyrimidine ring, a pyridazine ring, or a pyrazine ring is preferably formed. Among these rings, an imidazole ring and a pyridine ring are more preferable.

$L^1$ is preferably represented by formula (L1-1).

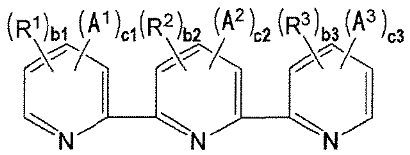

(L1-1)

• $A^1$, $A^2$, and $A^3$

In formula (L1-1), $A^1$, $A^2$, and $A^3$ each independently represent an acidic group. Examples of $A^1$, $A^2$, and $A^3$ include those exemplified as the acidic group Ac.

• $R^1$ to $R^3$

$R^1$ to $R^3$ each independently represent a substituent. Examples of $R^1$ to $R^3$ include the substituent T described below. $R^1$ to $R^3$ each are preferably an alkyl group, a heteroaryl group, an aryl group, a heteroaryl group linked through a vinyl group, or an aryl group linked through a vinyl group.

• b1 to b3, and c1 to c3

b1, b3, and c1, c3 each independently represent an integer of 0 to 4, and b2 and c2 each independently represent an integer of 0 to 3. There is no case where all of c1 to c3 are 0.

$L^1$ is more preferably represented by formula (L1-2).

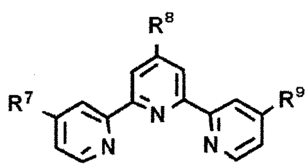

: (L1-2)

• $R^7$ to $R^9$

In formula (L1-2), $R^7$, $R^8$, and $R^9$ each independently represent a hydrogen group, an alkyl group, a heteroaryl group, an aryl group, or an acidic group. At least one of $R^7$, $R^8$, and $R^9$ is an acidic group, and preferable examples of the acidic group include the acidic group Ac.

• m1

m1 is 1 or 2, and preferably 1.

• $L^2$

$L^2$ is represented by formula (L2).

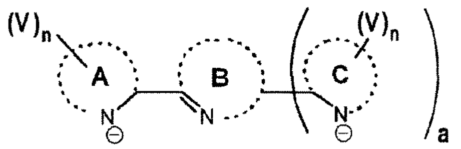

: (L2)

• V

V represents a substituent. V preferably represents a substituent having a positive σp value of Hammett's Rule.
The σp value of V is preferably 0.05 or higher, and more preferably 0.10 or higher. There is no particular upper limit for the σp value, but the upper limit is practically 1 or less. When a substituent having such a σp value is employed, a shift of the wavelength to be longer than the wavelength of absorbed light can be realized, while durability and the conversion efficiency are maintained.
The expression "Hammett substituent constant σp value" used herein will be described. The Hammett's Rule is an empirical rule proposed by L. P. Hammett in 1935 to discuss quantitatively the influence of substituents on the reaction or equilibrium of benzene derivatives, and its validity is approved widely nowadays. The substituent constant determined with the Hammett's Rule includes σp value and σm value, and these values can be found in many general literatures and books. For example, such values are described in detail, for example, in "Lange's Handbook of Chemistry", 12th edition (1979), edited by J. A. Dean (McGraw-Hill); "Kagaku No Ryoiki" ("Region of Chemistry"), extra edition, No. 122, pp. 96-103 (1979) (Nankodo); "Chemical Reviews", Vol. 91, pp. 165-195 (1991); and by Corwin Hansch, A. LEO, and R. W. TAFT, "A Survey of Hammett Substituent Cosntants and Resonance and Field Parameters", Chem. Rev. 1991, 91, 165-195.
When there are a plurality of substituents V's are present in one hetero ring, that is, when n is 2 or larger, an evaluation is conducted based on the sum of the σp values of the substituents V's. However, an evaluation should be carried out for each hetero ring, and for V's that are substituted on different hetero rings, the evaluation cannot be carried out based on the sum, but the evaluation should be based on the respective σp value.
It is preferable that at least one V be a substituent containing a heterocyclic group. According to this, ε is increased, and the IPCE is enhanced. As a result, a noticeable enhancement in the conversion efficiency can be observed.
Preferred examples of a hetero ring that constitutes the heterocyclic group include thiophene, furan, pyrrole, pyrazole, imidazole, triazole, tetrazole, oxazole, isoxazole, thiazole, isothiazole, pyridine, pyrimidine, pyridazine, pyrazine, benzo fused-ring derivatives thereof, and triazine.
It is also preferable that V be an alkyl group. In the case of an alkyl group, the number of carbon atoms is preferably 1 to 18, more preferably 2 to 14, and particularly preferably 4 to 10. The alkyl group may have a substituent T described below.

• n

n represents an integer of 0 or more, preferably an integer of 1 to 5, further preferably an integer of 1 to 3.

• A and C

A and C each are preferably represented by any one of formulas (L2-1) to (L2-11).

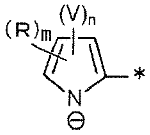 : (L2-1) 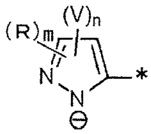 : (L2-2) 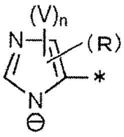 : (L2-3)

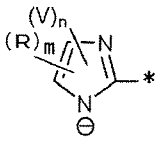 : (L2-4) 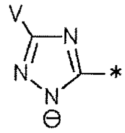 : (L2-5) 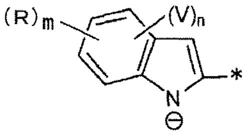 : (L2-6)

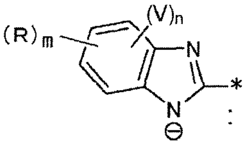 : (L2-7) 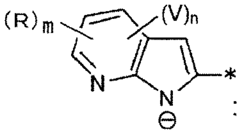 : (L2-8) 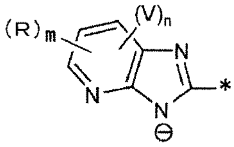 : (L2-9)

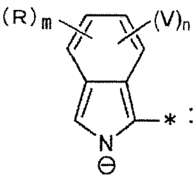 : (L2-10) 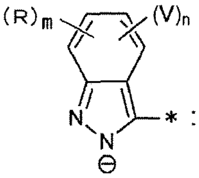 : (L2-11)

In the formulas, V has the same meaning as V in formula L2; n has the same meaning as n in formula L2; and these also have the same preferable ranges. However, the upper limit of each of them is the "number of substitutable positions" of each ring structure. Symbol * represents a bonding position. R represents a substituent, and m represents an integer of 0 or more. The upper limit of m is the "number of substitutable positions" in each formula, and in formula L2-1, the upper limit is 3. When m is 2 or greater, a plurality of R's may be identical with or different from each other. Examples of R include the substituent T described below, and preferred examples include an alkyl group, an aryl group, and a heterocyclic group. In formulas (L2-6), (L2-8), and (L2-10), R and V mean to include those substituted on the pyrrole ring.

It is preferable that A and C each be represented by any one of formulas (L2-2) to (L2-6), and (L2-9).

•B

B represents a nitrogen-containing aromatic ring having a 5-membered or higher-membered ring, and preferably a 5-membered to 14-membered ring, which may be substituted. The thus-formed ring may be substituted or unsubstituted, and may be a single ring or a condensed ring. B is preferably composed of at least one of a carbon atom, a hydrogen atom, a nitrogen atom, an oxygen atom, a sulfur atom, a phosphorus atom, and a halogen atom, more preferably forms an aromatic ring. In the case of the 5-membered ring, an imidazole ring, an oxazole ring, a thiazole ring, or a triazole ring is preferably formed. In the case of the 6-membered ring, a pyridine ring, a pyrimidine ring, a pyridazine ring, or a pyrazine ring is preferably formed.

B is preferably represented by formula (L2-21) or (L2-22).

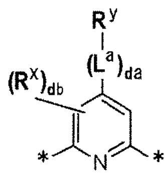 : (L2-21) 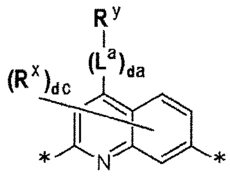 : (L2-22)

• $R^x$ and $R^y$

In formulas (L2-21) and (L2-22), $R^x$ represents a substituent. Examples of $R^x$ include the substituent T described below. $R^y$ represents a hydrogen atom, an alkyl group, an aryl group, or a heterocyclic group. $R^y$ is preferably an aryl group or a heterocyclic group.

When $R^y$ is a heterocyclic group, more preferred examples thereof include thiophene, furan, pyrrole, selenophene, and benzo fused-ring derivatives thereof; a heterocyclic group in which two or more rings are linked, with the aforementioned rings being included therein per se; thienothiophene, dithienothiophene, dithienocyclopentane, and dithienosilole.

Symbol * means a bonding hand.

• da, db, and dc

da represents an integer of 0 to 5. db represents an integer of 0 to 2. dc represents an integer of 0 to 4.

• $L^a$

$L^a$ is a linking group having the same meanings as $L^c$ and $L^d$ defined in L3 in formula (II) described below.

• a

a represents an integer of 0 or 1.

•m2

m2 represents an integer of 0 or 1, preferably 1.

•X

X represents a monodentate ligand. X is preferably a monodentate ligand which coordinates through a coordinating group selected from the group consisting of an acyloxy group, an acylthio group, a thioacyloxy group, a thioacylthio group, an acylaminooxy group, a thiocarbamate group, a dithiocarbamate group, a thiocarbonate group, a dithiocarbonate group, a trithiocarbonate group, an acyl group, a thiocyanate group, an isothiocyanate group, a cyanate group, an isocyanate group, a cyano group, an alkylthio group, an arylthio group, an alkoxy group, and an aryloxy group; or a monodentate ligand selected from the group consisting of a halogen atom, a carbonyl, a dialkylketone, a carbonamide, a thiocarbonamide, or a thiourea.

In the case where the ligand X includes an alkyl group, an alkenyl group, an alkynyl group, an alkylene group, or the like, these groups each may be linear or branched, and may be substituted or unsubstituted. In the case where the ligand X includes an aryl group, a heterocyclic group, a cycloalkyl group, or the like, these groups each may be substituted or unsubstituted, and may be a single ring or a condensed ring. The ligand X may become an anion or a cation of each group described above, to coordinate the central metal.

• mX

mX represents the number of ligands represented by X. mX represents an integer of 0 to 3, preferably 0 or 1, and more preferably 1.

• CI

CI in formula (I) represents a counter ion in the case where the counter ion is necessary to neutralize the charge. Generally, whether the dye is cationic or anionic, or has a net ionic charge, depends on the metal, the ligands, and the substituents in the dye.

In the case where the substituent has a dissociative group or the like, the dye represented by formula (I) may have a negative charge arising from dissociation. In this case, an electric charge of the dye represented by formula (I) as a whole is electrically neutralized by the counter ion CI.

When the counter ion CI is a positive counter ion, examples of the counter ion CI include an inorganic or organic ammonium ion (for example, tetraalkyl ammonium ion, pyridinium ion, and the like), a phosphonium ion (for example, tetraalkyl phosphonium ion, alkultriphenyl phosphonium ion, and the like), an alkali metal ion, and a proton.

When the counter ion CI is a negative counter ion, the negative counter ion may be, for example, an inorganic negative ion or an organic negative ion. Examples thereof include a halogen negative ion (for example, fluoride ion, chloride ion, bromide ion, iodide ion, and the like), a substituted arylsulfonate ion (for example, p-toluenesulfonate ion, p-chlorobenzenesulfonate ion, and the like), an aryldisulfonate ion (for example, 1,3-benzenedisulfonate ion, 1,5-naphthalenedisulfonate ion, 2,6-naphthalenedisulfonate ion, and the like), an alkylsulfate ion (for example, methylsulfate ion, and the like), a sulfate ion, a thiocyanate ion, a perchlorate ion, a tetrafluoroborate ion, a hexafluorophosphae ion, a picrate ion, an acetate ion, and a trifluoromethanesulfonate ion. Alternatively, as a charge balance counter ion, an ionic polymer or another dye with the opposite charge from the primary dye may be used. Alternatively, a metal complex ion (for example, bisbenzene-1,2-dithiolatonickel (III), and the like) may be used.

Specific examples of the dye having the structure represented by formula (I) are shown below, but the present invention is not limited thereto.

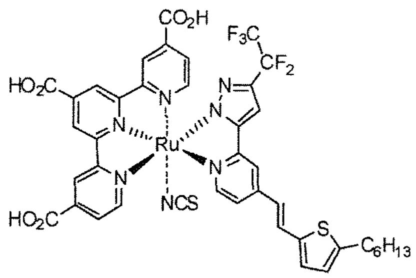

(II-1)

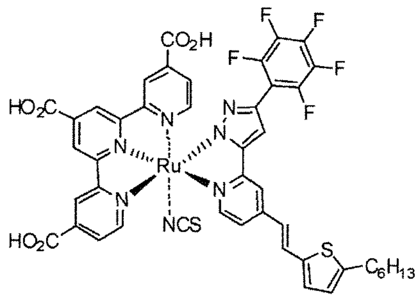

(II-2)

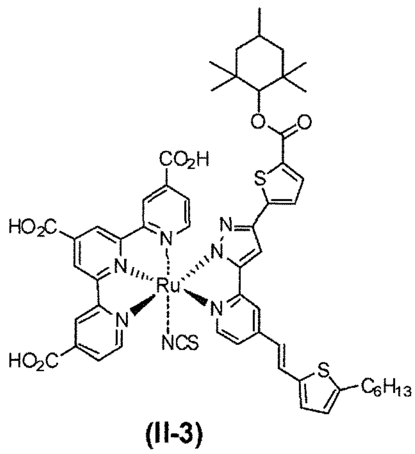

(II-3)

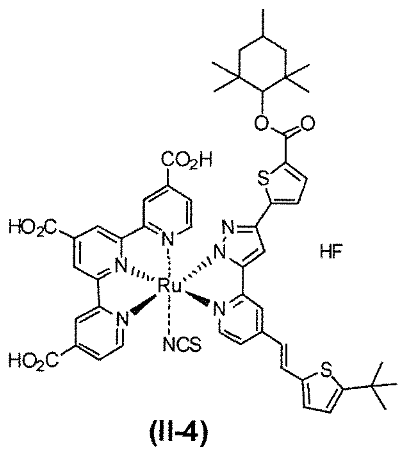

(II-4)

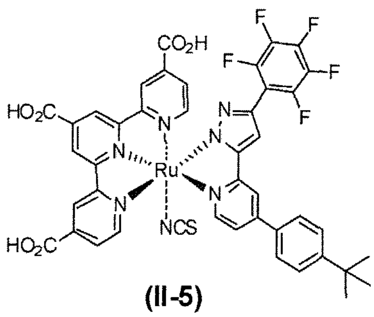

(II-5)

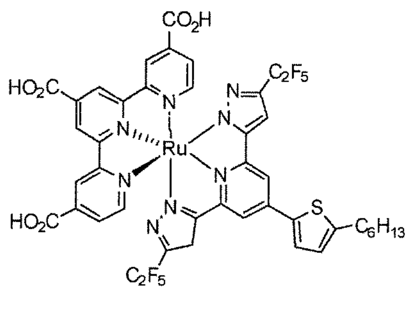

(II-6)

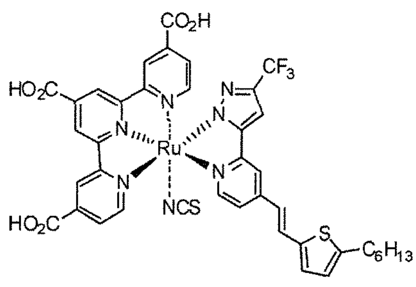

(II-7)

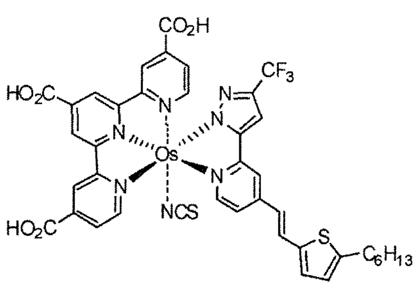

(II-8)

Synthesis of the dye represented by formula (I) can be carried out in a usual manner. Reference can be made to Chem. Commun., 2009, 5844-5846; US 2010/0258175 A1, and the like.

(Dye represented by formula (II))

$$ML^3_{m3}L^4_{m4}Y_{mY}\cdot CI \qquad (II)$$

• Metal atom M

M has the same meaning as M in formula (I).

• $L^3$

$L^3$ represents a bidentate ligand represented by formula (L3).

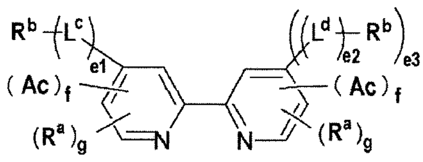

: (L3)

• m3

m3 is an integer of 0 to 2, preferably 1 or 2, and more preferably 1. When m3 is an integer of 2 or more, $L^3$'s may be the same as or different from each other; {0065}

• Ac

Ac's each independently represent an acidic group. Preferable examples of Ac have the same meanings as defined in formula (I). Ac may substitute on an arbitrary atom on a pyridine ring or a substituent thereon.

• $R^a$

$R^a$'s each independently represent a substituent. As the preferable substituent of $R^a$, the substituent T can be mentioned. $R^a$ is preferably an alkyl group, an alkenyl group, a cycloalkyl group, an aryl group, a heterocyclic group, an alkoxy group, an aryloxy group, an alkoxycarbonyl group, an amino group, an acyl group, a sulfonamide group, an acyloxy group, a carbamoyl group, an acylamino group, a cyano group, or a halogen atom; more preferably an alkyl group, an alkenyl group, an aryl group, a heterocyclic group, an alkoxy group, an alkoxycarbonyl group, an amino group, an acylamino group, or a halogen atom; and particularly preferably an alkyl group, an alkenyl group, an alkoxy group, an alkoxycarbonyl group, an amino group, or an acylamino group.

• $R^b$

$R^b$ represents an alkyl group or an aromatic group. The aromatic group is preferably an aromatic group having 6 to 30 carbon atoms, for example, phenyl, a substituted phenyl, naphthyl, or a substituted naphthyl. The heterocyclic group is preferably a heterocyclic group having 1 to 30 carbon atoms, for example, 2-thienyl, 2-pyrrolyl, 2-imidazolyl, 1-imidazolyl, 4-pyridyl, 3-indolyl, or a group obtained by combining two or more of these including the rings per se. A heterocyclic group having 1 to 3 electron donative groups is more preferable, and further preferably thienyl or a group formed by linking two or more thienyls. The electron donative group is preferably an alkyl group, an alkenyl group, an alkynyl group, a cycloalkyl group, an alkoxy group, an aryloxy group, an amino group, an acylamino group, or a hydroxyl group; more preferably an alkyl group, an alkoxy group, an amino group, or a hydroxyl group; and particularly preferably an alkyl group.

• e1 and e2

e1 and e2 each independently are an integer of 0 to 5, preferably an integer of 0 to 3, more preferably an integer of 0 to 2.

• $L^c$ and $L^d$

$L^c$ and $L^d$ each independently represent a conjugated chain, and examples thereof include a conjugated chain composed of at least one selected from the group consisting of an arylene group, a heteroarylene group, an ethenylene group, and an ethynylene group. The ethenylene group, the ethynylene group, and the like may be unsubstituted or may have a substituent. In the case where the ethenylene group has a substituent, the substituent is preferably an alkyl group, and more preferably a methyl group. Preferably $L^c$ and $L^d$ each independently are a conjugated chain having 2 to 6 carbon atoms; more preferably thiophenediyl, ethenylene, butadienylene, ethynylene, butadiynylene, methylethenylene, or dimethylethenylene; especially preferably ethenylene or butadienylene; and most preferably ethenylene. $L^c$ and $L^d$ may be the same as or different from each other, but it is preferable that $L^c$ and $L^d$ are the same. When the conjugated chain contains a carbon-carbon double bond, each carbon-carbon double bond may have a E configuration or a Z configuration, or a mixture thereof.

• e3

e3 is 0 or 1. Especially, when e3 is 0, f in formula (L3) shown on the right side of the paper is preferably 1 or 2, and similarly when e3 is 1, f shown on the right side of the paper is preferably 0 or 1.

• g

g's each independently represent an integer of 0 to 3, preferably an integer of 0 to 2.

• f

f's each independently represent an integer of 0 to 3. When the total of f is 1 or more and the ligand $L^3$ has at least one acidic group, m3 in formula (II) is preferably 2 or 3, and more preferably 2. When f is 2 or more, a plurality of Ac's may be the same as or different from each other. In formula (L3), f shown on the left side of the paper is preferably 0 or 1, and similarly f shown on the right side of the paper is preferably an integer of 0 to 2. The total of f's of the left and right sides of the paper is preferably an integer of 0 to 2.

The ligand $L^3$ in formula (II) is preferably a ligand represented by formula (L3-1), (L3-2), or (L3-3).

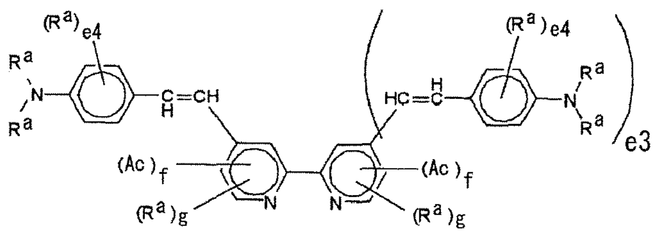

(L3-1)

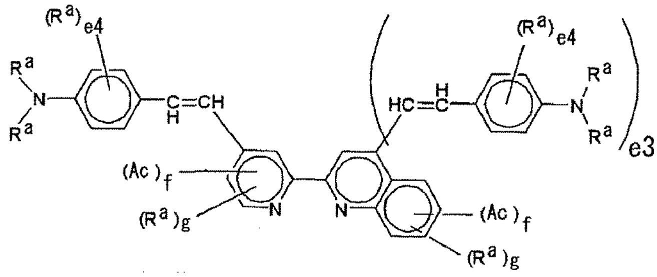

(L3-2)

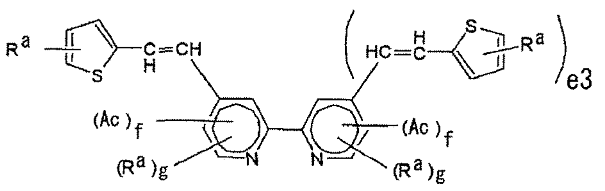

(L3-3)

In formulae (L3-1), (L3-2), and (L3-3), Ac, Ra, f, g, and e3 have the same meanings as those in formula (L3),

respectively. Ra substituted at the N-position may be a hydrogen atom. e4 represents an integer of 0 to 4. Ra and Ac each may be substituted at any position of the adjacent rings.

• $L^4$

$L^4$ represents a bidentate or tridentate ligand represented by formula (L4).

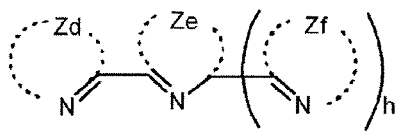
: (L4)

In formula (L4), Zd, Ze, and Zf represent a group of atoms for forming a 5- or 6-membered ring. h represents 0 or 1. At least one ring formed with Zd, Ze, and Zf has an acidic group Ac.

• m4

m4 is an integer of 1 to 3, and preferably 1 or 2. When m4 is 2 or more, a plurality of $L^4$'s may be the same as or different from each other.

• Zd, Ze, and Zf

Zd, Ze, and Zf have the same meanings as Za, Zb, and Zc in formula (I), respectively.

• h

h represents 0 or 1. h is preferably 0, and $L^4$ is preferably a bidentate ligand.
The ligand $L^4$ is preferably a ligand represented by any one of formulae (L4-1) to (L4-8), more preferably a ligand represented by formula (L4-1), (L4-2), (L4-4), or (L4-6), further preferably a ligand represented by formula (L4-1) or (L4-2), and particularly preferably a ligand represented by formula (L4-1).

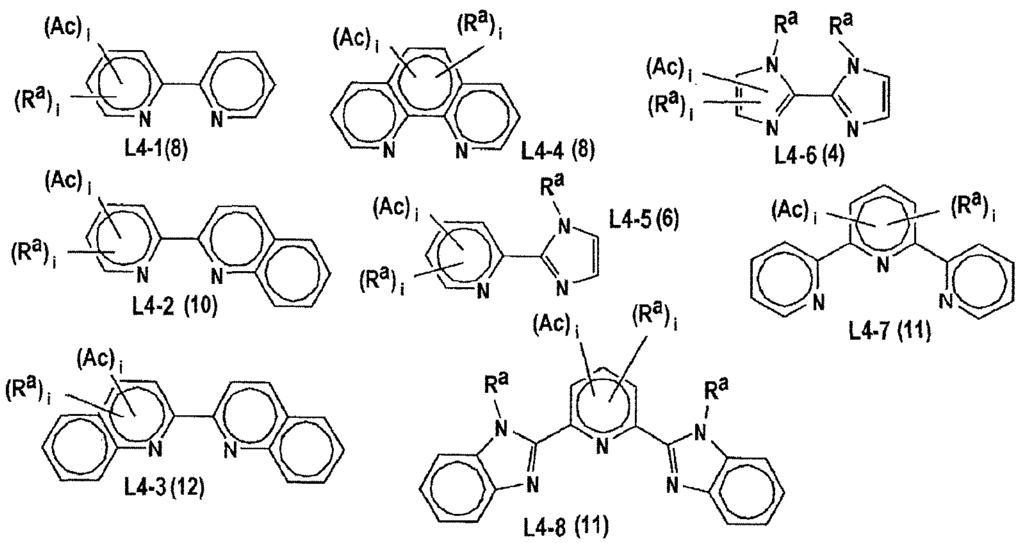
L4-1(8) L4-4 (8) L4-6 (4)
L4-5 (6) L4-2 (10) L4-7 (11)
L4-3 (12) L4-8 (11)

In formulae (L4-1) to (L4-8), Ac's each independently represent an acidic group or a salt thereof. Ac is preferably the aforementioned acidic group Ac.
In formulae (L4-1) to (L4-8), $R^a$ has the same meaning as that of formula (I). $R^a$ which is substituted at N-position may be a hydrogen atom.
i's each independently represent the number (an integer) ranging from 0 to the number of positions of carbons each of which may have a substituent. The number of possible substituents is shown in parenthesis at a side to the formula number. A plurality of $R^a$'s may be linked or condensed each other, to form a ring.

Although each of the substituents $R^a$ in formulae L4-1 to L4-8 reaches up its atomic bonding for the predetermined aromatic ring, $R^a$ is not limited to the substitution on the aromatic ring. That is to say, for example, although formula L4-1 shows a configuration in which the pyridine ring on the paper left side is substituted with Ac or $R^a$, the configuration may be such that the pyridine ring on the paper right side may be substituted with those.

• Y

In formula (II), Y represents a monodentate or bidentate ligand. mY represents the number of ligands Y's. mY represents an integer of 0 to 2, and mY is preferably 1 or 2. When Y is a monodentate ligand, mY is preferably 2; and when Y is a bidentate ligand, mY is preferably 1. When mY is 2 or more, a plurality of Y's may be the same as or different from each other; and the plurality of Y's may bond together.

The ligand Y is preferably a ligand which coordinates via a group selected from the group consisting of an acyloxy group, a thioacylthio group, an acylaminooxy group, a dithiocarbamate group, a dithiocarbonate group, a trithiocarbonate group, a thiocyanate group, an isothiocyanate group, a cyanate group, an isocyanate group, a cyano group, an alkylthio group, an arylthio group, an alkoxy group, and an aryloxy group, or a ligand composed of a halogen atom, carbonyl, a 1,3-diketone, or a thiourea; more preferably a ligand which coordinates via a group selected from the group consisting of an acyloxy group, an acylaminooxy group, a dithiocarbamate group, a thiocyanate group, an isothiocyanate group, a cyanate group, an isocyanate group, a cyano group, and an arylthio group, or a ligand composed of a halogen atom, a 1,3-diketone, or a thiourea; especially preferably a ligand which coordinates via a group selected from the group consisting of a dithiocarbamate group, a thiocyanate group, an isothiocyanate group, a cyanate group, and an isocyanate group, or a ligand composed of a halogen atom, or a 1,3-diketone; most preferably a ligand which coordinates via a group selected from the group consisting of a dithiocarbamate group, a thiocyanate group, and an isothiocyanate group, or a ligand composed of a 1,3-diketone. In the case where the ligand Y contains an alkyl group, an alkenyl group, an alkynyl group, an alkylene group, or the like, these each may be a straight chain or a branched chain, and may be substituted or unsubstituted. Further, in the case where the ligand Y contains an aryl group, a heterocyclic group, a cycloalkyl group, or the like, these each may be substituted or unsubstituted, and may be a single ring or a condensed ring.

In the case where Y is a bidentate ligand, Y is preferably a ligand which coordinates via a group selected from the group consisting of an acyloxy group, an acylthio group, a thioacyloxy group, a thioacylthio group, an acylaminooxy group, a thiocarbamate group, a dithiocarbamate group, a thiocarbonate group, a dithiocarbonate group, a trithiocarbonate group, an acyl group, an alkylthio group, an arylthio group, an alkoxy group, and an aryloxy group, or a ligand composed of a 1,3-diketone, a carbonamide group, a thiocarbonamide group, or a thiourea. In the case where Y is a monodentate ligand, Y is preferably a ligand which coordinates via a group selected from the group consisting of a thiocyanate group, an isothiocyanate group, a cyanate group, an isocyanate group, a cyano group, an alkylthio group, and an arylthio group, or a ligand composed of a halogen atom, carbonyl, a dialkylketone, or a thiourea.

The ligand Y may become an anion or a cation of each group described above, to coordinate the central metal.

•CI

CI in formula (II) represents a counter ion in the case where the counter ion is necessary to neutralize the charge. CI in formula (II) has the same meaning as CI in formula (I), and a preferred range thereof is also the same.

Specific examples of the dye having a structure represented by formula (II) are shown below, but the present invention is not limited thereto. In the case where a dye in the following specific examples contains a ligand having a proton-dissociable group, the ligand may release a proton with dissociation as needed.

Compound 1

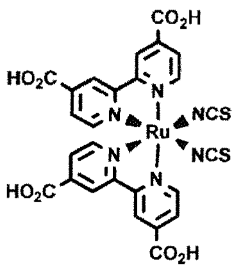

N3

Compound 2

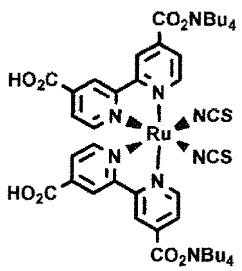

N719

Compound 3

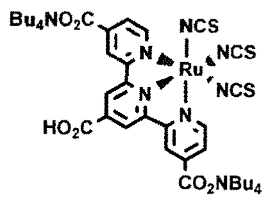

Black Dye

N749

Compound 4

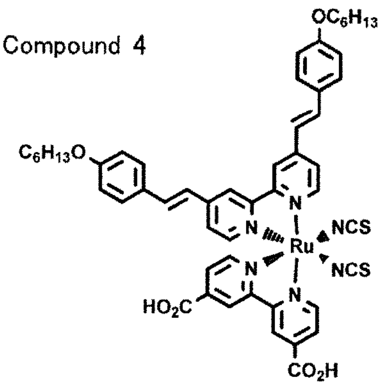

Compound 5

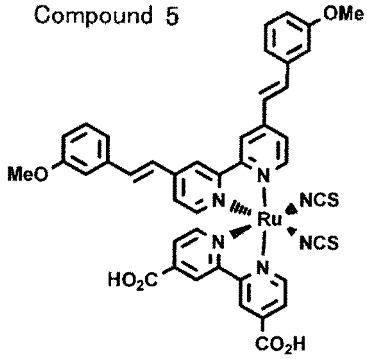

Compound 6

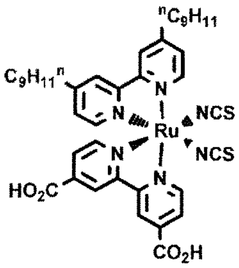

Compound 7

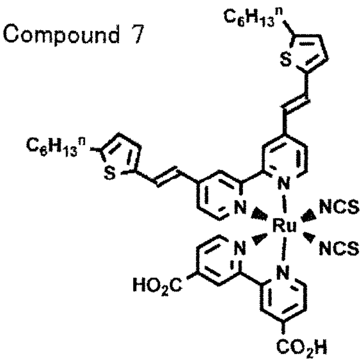

Compound 8

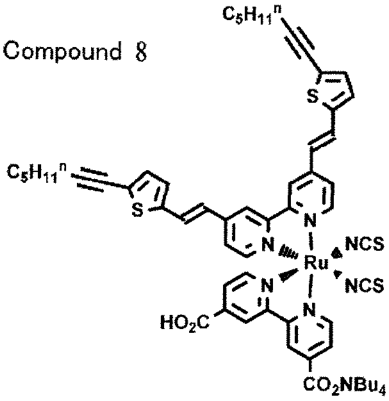

(J2)

Compound 9

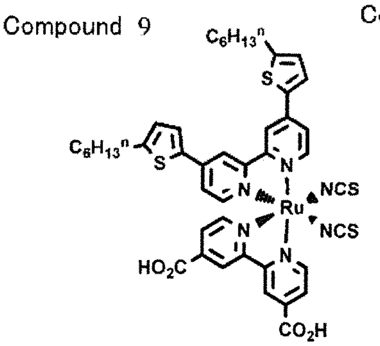

Compound 10

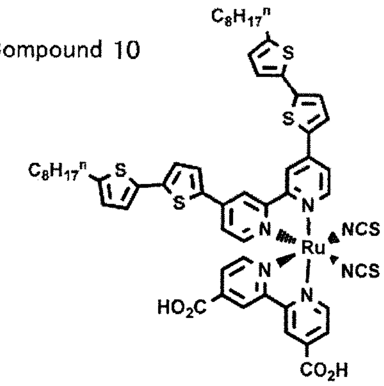

Compound 11

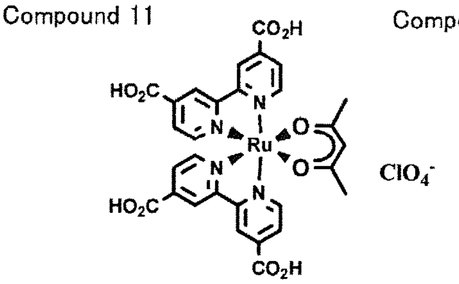

Compound 12

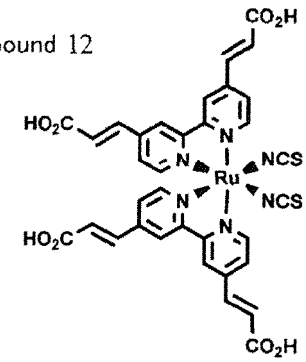

Compound 13

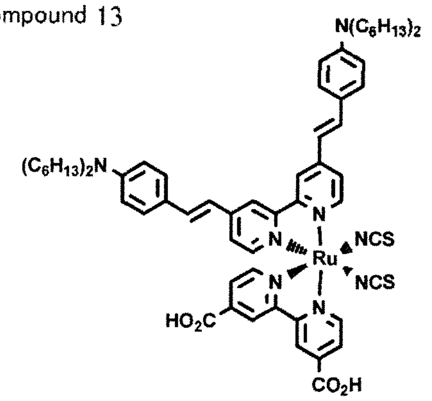

Compound 14

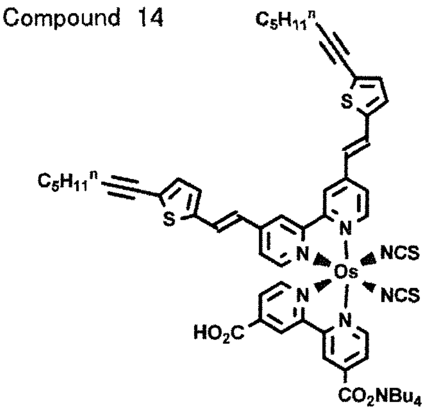

The dye represented by formula (II) can be synthesized, with reference to methods described in JP-A-2001-291534, and methods that are cited in this Japanese patent application publication.

The dye represented by formula (I) or (II) has a maximum absorption wavelength in a solution in a range of preferably from 300 to 1,000 nm, more preferably from 350 to 950 nm, and especially still more preferably from 370 to 900 nm.

In the photoelectric conversion element and the photoelectrochemical cell of the present invention, high conversion efficiency can be secured, through use of light of a wide range of wavelengths, by means of at least the dye represented by formula (I) and the dye represented by formula (II).

With respect to the blend ratio of the dye represented by formula (II) and the dye represented by formula (I), provided that the former is designated as R while the latter as S, R/S in terms of mole % ratio is generally from 95/5 to 10/90, preferably from 95/5 to 50/50, more preferably from 95/5 to 60/40, still more preferably from 95/5 to 65/35, and most preferably from 95/5 to 70/30.

In the present specification, with respect to the term "compound" (including the complex and dye), an expression of the compound is utilized to mean to include not only the compound itself, but also a salt, complex, or ion thereof. Further, the expression of the compound is also utilized to mean to include derivatives thereof in which a given part is changed, to an extent necessary to exhibit the desired effects.

A substituent with which substitution or non-substitution is not explicitly described in the present specification, means that the substituent may have another arbitrary substituent thereon (the same is applied to a linking group and a ligand). The same is true on a compound with which substitution or non-substitution is not explicitly described. Preferable examples of the substituent include the following substituent T. Furthermore, when a substituent represents a ligand, this means that the ligand may become an anion or a cation, to coordinate the central metal.

The substituent T includes the followings:

an alkyl group (preferably an alkyl group having 1 to 20 carbon atoms, e.g. methyl, ethyl, isopropyl, t-butyl, pentyl, heptyl, 1-ethylpentyl, benzyl, 2-ethoxyethyl, or 1-carboxymethyl), an alkenyl group (preferably an alkenyl group having 2 to 20 carbon atoms, e.g. vinyl, allyl, or oleyl), an alkynyl group (preferably an alkynyl group having 2 to 20 carbon atoms, e.g. ethynyl, butadiynyl, or phenylethynyl), a cycloalkyl group (preferably a cycloalkyl group having 3 to 20 carbon atoms, e.g. cyclopropyl, cyclopentyl, cyclohexyl, or 4-methylcyclohexyl), an aryl group (preferably an aryl group having 6 to 26 carbon atoms, e.g. phenyl, 1-naphthyl, 4-methoxyphenyl, 2-chlorophenyl, or 3-methylphenyl), a heterocyclic group (preferably a heterocyclic group having 2 to 20 carbon atoms, preferably a 5- or 6-membered heterocyclic group having 2 to 20 carbon atoms and having at least one oxygen atom, sulfur atom, or nitrogen atom, e.g. 2-pyridyl, 4-pyridyl, 2-imidazolyl, 2-benzimidazolyl, 2-thiazolyl, or 2-oxazolyl), an alkoxy group (preferably an alkoxy group having 1 to 20 carbon atoms, e.g. methoxy, ethoxy, isopropyloxy, or benzyloxy), an aryloxy group (preferably an aryloxy group having 6 to 26 carbon atoms, e.g. phenoxy,1-naphthyloxy, 3-methylphenoxy, or 4-methoxyphenoxy), an alkoxycarbonyl group (preferably an alkoxycarbonyl group having 2 to 20 carbon atoms, e.g. ethoxycarbonyl, or 2-ethylhexyloxycarbonyl), an amino group (preferably an amino group having 0 to 20 carbon atoms including an alkylamino group, and an arylamino group, e.g. amino, N,N-dimethylamino, N,N-diethylamino, N-ethylamino, or anilino), a sulfamoyl group (preferably a sulfonamide group having 0 to 20 carbon atoms, e.g. N,N-dimethylsulfamoyl, or N-phenylsulfamoyl), an acyloxy group (preferably an acyloxy group having 1 to 20 carbon atoms, e.g. acetyloxy, or benzoyloxy), a carbamoyl group (preferably a carbamoyl group having 1 to 20 carbon atoms, e.g. N,N-dimethylcarbamoyl, or N-phenylcarbamoyl), an acylamino group (preferably an acylamino group having 1 to 20 carbon atoms, e.g. acetylamino, or benzoylamino), a sulfonamide group (preferably a sulfamoyl group having 0 to 20 carbon atoms, e.g. methanesulfonamide, benzenesulfonamide, N-methyl methanesulfonamide, or N-ethylbenzenesulfonamide), a hydroxyl group, a cyano group, and a halogen atom (e.g. fluorine, chlorine, bromine, or iodine); more preferably an alkyl group, an alkenyl group, an aryl group, a heterocyclic group, an alkoxy group, an aryloxy group, an alkoxycarbonyl group, an amino group, an acyamino group, a cyano group, or a halogen atom; and particularly preferably an alkyl group, an alkenyl group, a heterocyclic group, an alkoxy group, an alkoxycarbonyl group, an amino group, an acylamino group, or a cyano group.

When the compound, the substituent, or the like, contain an alkyl group or an alkenyl group, each of these may be a straight chain or a branched chain, and may be substituted or unsubstituted. Further, in the case of containing an aryl group, a heterocyclic group, or the like, each of these may be a single ring or a condensed ring, and may be substituted or unsubstituted.

[Photoelectric conversion element and dye-sensitized solar cell]

The photoelectric conversion element according to a preferred embodiment of the present invention has: an electrically-conductive support (including a substrate and a transparent electrode); a photoconductor layer (including semiconductor fine-particles, and a sensitizing dye having an adsorbing group); an electrolyte layer; and a counter electrode, in which the photoelectric conversion element is equipped with a member to insulate the transparent electrode and the counter electrode, so as to keep the photoconductor layer and the electrolyte layer. For example, as shown in Fig. 1, the photoelectric conversion element 10 has an electrically-conductive support 1 composed of a substrate and a transparent electrode; a semiconductor layer (photoconductor layer) 2 provided thereon and sensitized by a dye 21; an electrolyte layer 3; and a counter electrode 4. In the present invention, it is preferable that, together with the dye 21, a co-adsorbent (not shown in the figure) be adsorbed to the semiconductor layer. The electrically-conductive support 1 having a semiconductor layer provided thereon functions as a working electrode in the photoelectric conversion element 10. In this embodiment, the photoelectric conversion element 10 is shown as a system 100, utilizing a dye-sensitized solar cell which enables the photoelectric conversion element 10 to use in a cell purpose which lets an operation means M to work with an external circuit 6.

In this embodiment, the light-receiving electrode 5 is composed of an electrically-conductive support 1, and a photoconductor layer 2 coated on the electrically-conductive support 1, with the layer 2 having semiconductor fine-particles 22 to which a dye 21 has been adsorbed. In this embodiment, as a matter of convenience for showing in the figure, it is illustrated such that the light-receiving electrode 5 can contain an electrolyte. The boundary is not strictly defined, and as shown in the figure, the light-receiving electrode and electrolyte may be brought into contact at a surface with a convexo-concave surface. The photoconductor layer 2, which is the semiconductor layer, is designed according to the intended purpose, and may have a monolayer structure or a multilayered structure. The dye 21 in one layer of the photoconductor layer may be one kind or a mixture of a plurality of kinds. A light incident to the photoconductor layer 2 including a semiconductor layer excites the dye 21. The thus-excited dye has electrons with high energy, and these electrons are transported from the dye 21 to the conduction band of the semiconductor fine-particles 22, to further reach the electrically-conductive support 1 by diffusion. At this time, the dye 21 is in an oxidized form. The electrons on the electrode, while working with the external circuit 6, return to the photoconductor layer 2 in which the oxide form of the dye 21 exists, through the counter electrode 4, whereby this works as a solar cell.

In the present invention, with respect to materials that can be used in the photoelectric conversion element and the dye-sensitized solar cell and methods of preparing each member, usual ones in this field of art may be used. On the materials and methods, reference may be made, for example, to U.S. Patent No. 4,927,721, U.S. Patent No. 4,684,537, U.S. Patent No. 5,084,365, U.S. Patent No. 5,350,644, U.S. Patent No. 5,463,057, U.S. Patent No. 5,525,440, JP-A-7-249790, JP-A-2004-220974, and JP-A-2008-135197. Hereinafter, a summary on principal members are described.

• Electrolyte composition

Examples of the redox pair contained in the electrolyte composition for use in the photoelectric conversion element of the present invention include: a combination of iodine and an iodide (for example, lithium iodide, tetrabutylammonium iodide, or tetrapropylammonium iodide); a combination of an alkylviologen (for example, methylviologen chloride, hexylviologen bromide, or benzylviologen tetrafluoroborate), and a reductant thereof; a combination of polyhydroxybenzenes (for example, hydroquinone or naphthohydroquinone), and an oxidant thereof; a combination of a divalent iron complex and a trivalent iron complex (for example, potassium ferricyanide, and potassium ferrocyanide); and a combination of a divalent cobalt complex and a trivalent cobalt complex. Among these, a combination of iodine and an iodide, and a combination of a divalent cobalt complex and a trivalent cobalt complex are preferred.

The cobalt complex is preferably represented by formula (A).

$$Co(L^4)_{ma}(X)_{mb}\cdot CI \qquad \text{Formula (A)}$$

In formula (A), $L^4$ represents a bidentate or terdentate ligand. X represents a monodentate ligand. ma represents an integer of 0 to 3. mb represents an integer of 0 to 6. CI represents a counter ion in the case where the counter ion is necessary to neutralize the charge. $L^4$ and X have the same meanings as those in formula (I).

The compound represented by formula (A) is preferably represented by any one of formulas (A-1) to (A-3).

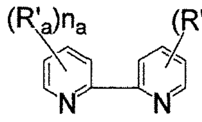
(A-1)

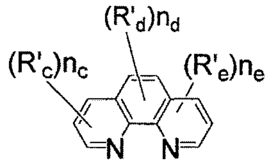
(A-2)

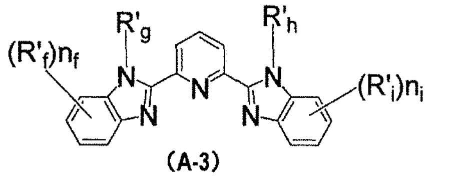
(A-3)

R'a to R'i each represent a substituent. na and nb each represent an integer of 0 to 4. nc and ne each represent an integer of 0 to 3. nd represents an integer of 0 to 2. nf and nj each represent an integer of 0 to 4. The substituents R'a to R'i are to substitute on the respective ring structure to which the atomic bonding is extended.

In formulas (A-1) to (A-3), examples of the substituent of R'a to R'i include an aliphatic group, an aromatic group, and a heterocyclic group. Specific examples of the substituent include an alkyl group, an alkoxy group, an alkylthio group, an aryl group, an aryloxy group, an arylthio group, and a heterocyclic group. Preferred examples include an alkyl group (e.g. methyl, ethyl, n-butyl, n-hexyl, isobutyl, sec-butyl, t-butyl, n-dodecyl, cyclohexyl, and benzyl), a substituted aryl group (e.g. phenyl, tolyl, and naphthyl), and an alkoxy group (e.g. methoxy, ethoxy, isopropoxy, and butoxy).

Specific examples of the cobalt complex represented by formula (A) include the following compounds.

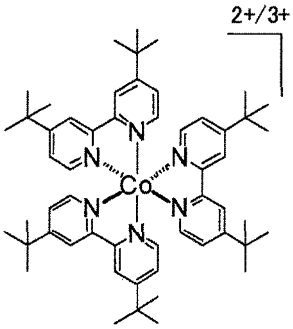
C-1

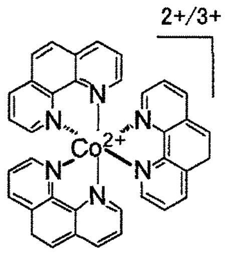
C-2

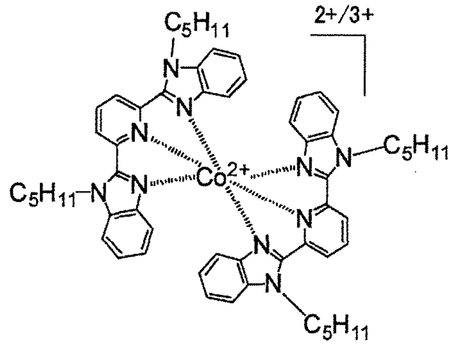
C-3

A cation of iodine salt is preferably a 5- or 6-membered nitrogen-containing aromatic cation. Especially, in the case where the compound represented by formula (A) is not an iodine salt, the compound represented by formula (A) is preferably used in combination with an iodine salt of pyridinium salts, imidazolium salts, triazolium salts, or the like, as described in Domestic re-publication of PCT international publication WO95/18456, JP-A-8-259543, and Denki Kagaku (Electrochemistry), Vol. 65, No. 11, page 923 (1997).

In the electrolyte composition that can be used in the photoelectric conversion element of the present invention, iodine is preferably contained with a heterocyclic quaternary salt compound. The content of iodine is preferably 0.1 to 20% by mass, more preferably 0.5 to 5% by mass, to the total of the electrolyte composition.

• Co-adsorbent

In the photoelectric conversion element of the present invention, a co-adsorbent is preferably used together with the metal complex dye of the present invention or with the dye used in combination therewith if necessary. As such a co-adsorbent, a co-adsorbent having a carboxyl group or a salt thereof is preferable, and examples of the co-adsorbent include a fatty acid, and a compound having a steroid skeleton. The fatty acid may be a saturated fatty acid or an unsaturated fatty acid. Examples thereof include a butanoic acid, a hexanoic acid, an octanoic acid, a decanoic acid, a hexadecanoic acid, a dodecanoic acid, a palmitic acid, a stearic acid, an oleic acid, a linoleic acid, and a linolenic acid.

Examples of the compound having a steroid skeleton include a cholic acid, a glycocholic acid, a chenodeoxycholic acid, a hyocholic acid, a deoxycholic acid, a lithocholic acid, and a ursodeoxycholic acid. Among these, a cholic acid, a deoxycholic acid, and a chenodeoxycholic acid are preferable; and a chenodeoxycholic acid is further preferable.

A preferred co-adsorbent is a compound represented by formula (B).

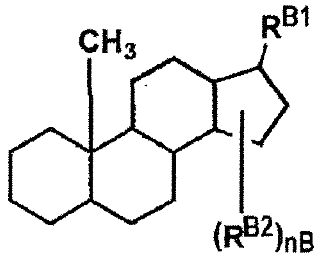

Formula (B)

In formula (B), $R^{B1}$ represents a substituent having an acidic group. $R^{B2}$ represents a substituent. nB represents an integer of 0 or more. The acidic group has the same meaning as the above-described Ac. nB is preferably an integer of 2 to 4. As specific examples of the substituent, the substituent T described above can be mentioned. As specific compounds, mention can be made of the examples of the above-mentioned compound having a steroid skeleton.

The co-adsorbent can exhibit, by adsorbing on the semiconductor fine-particles, an effect of suppressing the inefficient association of the dye. The amount to be used of the co-adsorbent is not particularly limited, but it is preferred that the amount thereof is preferably from 1 to 200 mole, more preferably from 10 to 150 mole, and particularly preferably from 20 to 50 mole, to mole of the sensitizing dye, from the viewpoints of effectively exhibiting the above action.

The electrically-conductive support is a support having electroconductivity per se, such as a metal, or a support of glass or a polymeric material having an electrically-conductive layer on the surface. As the support, in addition to the glass and the plastic, use may be made of ceramic (JP-A-2005-135902), or an electrically-conductive resin (JP-A-2001-160425). The support may be provided with a light management function at the surface. For example, mention may be made of the anti-reflective film having a high refractive index film and a low refractive index oxide film alternately laminated, as described in JP-A-2003-123859, and the light guide function, as described in JP-A-2002-260746.

The thickness of the electrically-conductive film layer is preferably 0.01 to 30 $\mu$m, more preferably 0.03 to 25 $\mu$m, and particularly preferably 0.05 to 20 $\mu$m.

• Electrically-conductive support

It is preferable that the electrically-conductive support is substantially transparent. The terms "substantially transparent" means that the transmittance of light is 10% or more, preferably 50% or more, particularly preferably 80% or more. As the transparent electrically-conductive support, a support formed from glass or a plastic and coated with an electrically-conductive metal oxide is preferable. In this case, the amount of coating of the electrically-conductive metal oxide is preferably 0.1 to 100 g per square meter of the support made of glass or a plastic. In the case of using a transparent electrically-conductive support, it is preferable that light is incident from the support side.

• Semiconductor fine-particles

The semiconductor fine-particles are preferably fine-particles of chalcogenides of metals (for example, oxides, sulfides, and selenides), or fine-particles of perovskites. Preferred examples of the chalcogenides of metals include: oxides of titanium, tin, zinc, tungsten, zirconium, hafnium, strontium, indium, cerium, yttrium, lanthanum, vanadium, niobium, or tantalum; cadmium sulfide; and cadmium selenide. Preferred examples of the perovskites include strontium titanate, and calcium titanate. Among these, titanium oxide, zinc oxide, tin oxide, and tungsten oxide are particularly preferred.

Examples of the crystal structure of titania include structures of anatase type, brookite type, and rutile type; and anatase type and brookite type structures are preferred, and the anatase type structure is particularly preferred. A titania nanotube/nanowire/nanorod may be mixed with titania fine-particles or may be used as a semiconductor electrode.

A particle size of the semiconductor fine-particles is expressed in terms of an average particle size using a diameter when a projected area is converted into a circle, and is preferably 1 to 1,000 nm as primary particles, and preferably 10 to 100,000 nm as an average particle size of a dispersion thereof, particularly preferably 20 to 300 nm. The semiconductor fine-particles are utilized preferably in two or more kinds of fine-particles, particularly preferably in three or more kinds thereof, different in average particle sizes each other. When a plurality of kinds of the fine-particles are used, it is preferable to use both particles having an average particle size of 10 to 50 nm, and particles having an average particle size of 100 to 200 nm. In regard to the particle shape, spherical particles or rod-shaped particles are preferably used, and it is more preferable to mix these. The mixing ratio is preferably that the proportion of rod-shaped particles is 20 to 40, when the total amount of particles would be 100. At this time, it is particularly preferable that spherical particles have an average particle size of 10 to 50 nm and rod-shaped particles have an average particle size of 100 to 200 nm.

Examples of the method of applying the semiconductor fine-particles onto the electrically-conductive support include a wet method, a dry method, or other methods.

It is preferable to form a short-circuit preventing layer between the transparent electrically-conductive film and the semiconductor layer (oxide semiconductor layer), in order to prevent reverse current due to a direct contact between the electrolyte liquid and the electrode. It is preferable to employ a spacer or a separator, so as to prevent the contact between the light-receiving electrode and the counter electrode. It is preferable for the semiconductor fine-particles to have a large surface area, so that a large amount of dye can adsorb to the surface. For example, while the support has been coated with the semiconductor fine-particles, the surface area is preferably 10 times or more, and more preferably 100 times or more, to the projected surface area. The upper limit of this value is not particularly limited, but the upper limit is generally about 5,000 times. In general, as the thickness of the semiconductor fine-particle layer increases, the amount of dye that can be supported per unit area increases, and therefore, the light absorption efficiency is increased. However, since the diffusion distance of thus-generated electrons increases along, the loss due to charge recombination is also increased. Although a preferred thickness of the semiconductor fine-particle layer (semiconductor layer) may vary with the usage of the resultant element, the thickness is typically 0.1 to 100 $\mu$m. In the case of using the photoelectric conversion element for a dye-sensitized solar cell, the thickness of the semiconductor fine-particle layer is preferably 1 to 50 $\mu$m, and more preferably 3 to 30 $\mu$m. The semiconductor fine-particles may be calcined after being applied on the support, at a temperature of 100 to 800°C for 10 minutes to 10 hours, so as to bring about cohesion of the particles. When a glass support is used, the film-forming temperature is preferably 400 to 60°C.

The amount of coating of the semiconductor fine-particles per square meter of the support is preferably 0.5 to 500 g, and more preferably 5 to 100 g. The overall amount to be used of the dye is preferably 0.01 to 100 millimoles, more preferably 0.1 to 50 millimoles, and particularly preferably 0.1 to 10 millimoles, per square meter of the support. In this case, the amount to be used of the dye of the present invention is preferably set to 5% by mole or more. The amount of the dye adsorbed to the semiconductor fine-particles is preferably 0.001 to 1 millimole, and more preferably 0.1 to 0.5 millimoles, to g of the semiconductor fine-particles. When the amount of the dye is set to such a range, the sensitization effect for the semiconductor can be sufficiently obtained. On the other hand, if the amount of the dye is too small, the sensitization effect is insufficient, and if the amount of the dye is too large, the portion of the dye that is not attached to the semiconductor is suspended, to cause lowering in the sensitization effect.

When the dye is a salt, a counter ion of the specific metal complex dye is not particularly limited. Examples thereof include an alkali metal ion, and a quaternary ammonium ion.

After the dye has been adsorbed, the surface of the semiconductor fine-particles may be treated with an amine. Preferred examples of the amines include 4-tert-butylpyridine, and polyvinylpyridine. These may be used directly when the compounds are liquids, or may be used in a state of being dissolved in an organic solvent. The charge-transfer layer is a layer having a function of supplementing electrons to an oxidant of the dye, and is provided between the light-receiving electrode and the counter electrode. Representative examples of the material forming the charge-transfer layer include a liquid prepared by dissolving a redox pair in an organic solvent, a so-called gel electrolyte obtained by impregnating a polymer matrix with a liquid prepared by dissolving a redox pair in an organic solvent, and a molten salt containing a redox pair.

A solid charge-transport system, such as a p-type semiconductor or a hole-transporting material, may also be used, instead of the liquid electrolytes and quasi-solid electrolytes described above. For the solid charge-transport layer, an organic hole-transporting material may be used.

The redox pair serves as a carrier for electrons, and thus is required at a certain concentration. A preferred overall concentration is 0.01 moles/L or more, more preferably 0.1 moles/L or more, and particularly preferably 0.3 moles/L or more. In this case, the upper limit of the concentration is not particularly limited, but it is generally about 5 moles/L.

• Counter electrode

The counter electrode is an electrode working as a positive electrode in the photoelectrochemical cell. The counter electrode generally has the same meaning as the electrically-conductive support described above, but in a construction which is likely to maintain a sufficient strength, a support is not necessarily required. A preferred structure of the counter electrode is a structure having a high charge-collecting effect. At least one of the electrically-conductive support and the counter electrode as mentioned above should be substantially transparent, in order for light to reach the photoconductor layer. In the photoelectrochemical cell of the present invention, the electrically-conductive support is preferably transparent, to allow sunlight to incident from the support side. In this case, the counter electrode has further preferably properties of reflecting light. As the counter electrode of the photoelectrochemical cell, a glass or a plastic on which a metal or an electrically-conductive oxide is deposited is preferable, and a glass on which platinum is deposited is particularly preferable. In the photoelectrochemical cell, a lateral side of the cell is preferably sealed with a polymer, an adhesive, or the like, in order to prevent evaporation of the components. The characteristics of the thus-obtained

photoelectrochemical cell of the present invention are: generally, 0.01 to 1.5 V in open-circuit voltage, 0.001 to 20 mA/cm$^2$ in short-circuit current density, 0.1 to 0.9 in shape factor, and 0.001 to 25% in conversion efficiency, in an operation of 100 mW/cm$^2$ at AM 1.5 G.

The present invention can be applied to the photoelectric conversion elements and dye-sensitized solar cells, as described in Japanese Patent No. 4260494, JP-A-2004-146425, JP-A-2000-340269, JP-A-2002-289274, JP-A-2004-152613, and JP-A-9-27352. Further, the present invention can be applied to the photoelectric conversion elements and dye-sensitized solar cells, as described in JP-A-2004-152613, JP-A-2000-90989, JP-A-2003-217688, JP-A-2002-367686, JP-A-2003-323818, JP-A-2001-43907, JP-A-2000-340269, JP-A-2005-85500, JP-A-2004-273272, JP-A-2000-323190, JP-A-2000-228234, JP-A-2001-266963, JP-A-2001-185244, JP-T-2001-525108 ("JP-T" means searched and published International patent publication), JP-A-2001-203377, JP-A-2000-100483, JP-A-2001-210390, JP-A-2002-280587, JP-A-2001-273937, JP-A-2000-285977, JP-A-2001-320068, JP-A-2010-218770, and the like.

EXAMPLES

The present invention will be described in more detail based on examples given below, but the invention is not meant to be limited by these.

(Example 1)

Pastes for forming a semiconductor layer or a light-scattering layer of a semiconductor electrode that constitutes a photoelectrode were prepared, to prepare dye-sensitized solar cells with the pastes.

[Preparation of pastes]

(Paste A) Spherical-shaped $TiO_2$ particles (anatase type, average particle size: 25 nm; hereinafter, referred to as spherical $TiO_2$ particles A) were introduced into a nitric acid solution, followed by stirring, to prepare a titania slurry. Then, a cellulose-based binder was added to the resultant titania slurry as a thickening agent, and the mixture was kneaded, to prepare a paste.

(Paste 1) Spherical $TiO_2$ particles A and spherical-shaped $TiO_2$ particles (anatase type, average particle size: 200 nm; hereinafter, referred to as spherical $TiO_2$ particles B) were introduced into a nitric acid solution, followed by stirring, to prepare a titania slurry. Then, a cellulose-based binder was added to the resultant titania slurry as a thickening agent, and the mixture was kneaded, to prepare a paste (mass of the $TiO_2$ particles A:mass of the $TiO_2$ particles B = 30:70).

(Paste 2) The paste A was mixed with rod-shaped $TiO_2$ particles (anatase type, diameter: 100 nm, aspect ratio: 5; hereinafter, referred to as rod-shaped $TiO_2$ particles C), to prepare a paste having a ratio of the mass of the rod-shaped $TiO_2$ particles C to the mass of the paste A of 30:70.

According to the procedures described below, a photoelectrode having the same configuration as that of the photoelectrode 12, as shown in Fig. 5 of JP-A-2002-289274, was prepared. Further, using the photoelectrode, a dye-sensitized solar cell 1 of a scale of 10 mm × 10 mm having the same configuration as that of the dye-sensitized solar cell 20, as shown in Fig. 3 of JP-A-2002-289274, except for the photoelectrode, was prepared. The specific configuration thereof was shown in Fig. 2 of the Drawings attached to the present application. In Fig. 2 of the present application, 41 stands for a transparent electrode, 42 stands for a semiconductor electrode, 43 stands for a transparent conductive film, 44 stands for a substrate, 45 stands for a semiconductor layer, 46 stands for a light-scattering layer, 40 stands for a photoelectrode, 20 stands for a dye-sensitized solar cell, CE stands for a counter electrode, E stands for an electrolyte, and S stands for a spacer.

A transparent electrode in which a fluorine-doped $SnO_2$ conductive film (thickness: 500 nm) was formed on a glass substrate, was provided. On this $SnO_2$ conductive film, the above paste 1 was applied by screen printing, followed by drying the paste. Then, the conductive film was calcined under the conditions of 450°C in the air. Furthermore, by repeating both the above screen printing and calcination using the paste 2, the semiconductor electrode having the same configuration as that of the semiconductor electrode 42, as shown in Fig. 2 (area of light-receiving face: 10 mm × 10 mm, layer thickness: 10 μm, layer thickness of the semiconductor layer: 6 μm, layer thickness of the light-scattering layer: 4 μm, and content of the rod-shaped $TiO_2$ particles C contained in the light-scattering layer: 30% by mass) was formed on the $SnO_2$ conductive film. Thus, a photoelectrode, which did not contain any sensitizing dye, was prepared.

Separately, a dye was adsorbed on the semiconductor electrodes (precursors of dye-adsorbed electrodes) as follows. First, anhydrous ethanol which had been dehydrated with magnesium ethoxide was used as a solvent, and the metal complex dye (0.04 mass%) described in the table below was dissolved in this anhydrous ethanol. The amount of water was adjusted so as to obtain the water content described in the table. Thus, a dye-adsorbing liquid was prepared. Then, the semiconductor electrode was immersed in this solution, and the semiconductor electrode was dried for 15 minutes under nitrogen gas flow at the pressure and temperature described in the table. Thereby, the dye was adsorbed

on the semiconductor electrode in an amount of about $1.5 \times 10^{-7}$ mol/cm$^2$. Thus, a photoelectrode 40 was completed.

Then, a platinum electrode (thickness of Pt thin film: 100 nm) having the same shape and size as those of the photoelectrode described above was provided as a counter electrode, and an iodine-based redox solution containing iodine and lithium iodide was prepared as an electrolyte E. Furthermore, a spacer-S (trade name: "Surlyn") manufactured by DuPont, which had a shape matching the size of the semiconductor electrode, was provided. The photoelectrode 40 and the counter electrode CE were arranged to face each other, with the spacer-S interposed therebetween, and the electrolyte described above was filled in the inside. Thus, a dye-sensitized solar cell was completed.

(Initial conversion efficiency)

A cell characterization test was carried out, and the photoelectric conversion efficiencies $\eta$ of the dye-sensitized solar cells were measured. The cell characteristics evaluation test was carried out using a solar simulator (manufactured by Wacom Electric, WXS-85-H type), by irradiating pseudo-sunlight of 1,000 W/cm$^2$, from a xenon lamp through an AM1.5 filter. The current-voltage characteristics were measured using an I-V tester, and the photoelectric conversion efficiency ($\eta_i$/%), Jsc, Voc, and FF (fill factor) were determined.

(Drop rate of conversion efficiency after storage in dark)

The photoelectric conversion efficiency ($\eta_f$) after the lapse of time period in the dark at 65°C for 300 hours was measured. An evaluation was carried out by determining the drop rate ($\gamma$d) (expression below) with respect to the initial conversion efficiency ($\eta_i$).

$$\text{Expression:} \quad \text{Drop rate } (\gamma d) = (\eta_i - \eta_f) / (\eta_i)$$

(Evaluation of fluctuation in performance)

Ten dye-sensitized solar cells were produced in the same manner, and the fluctuation ratio (SD) was determined as the ratio of the standard deviation of this photoelectric conversion efficiency ($\eta_i$) with respect to $\eta_i$.

(Thermally stimulated current)

Production of a sample was carried out according to the aforementioned Japanese Journal of Applied Physics, Vol. 47, No. 1, 2008, p. 505, using a platinum electrode-attached substrate, except that the processes from preparation of the paste to adsorption of the dye were carried out according to those for the preparation of the paste of the present invention.

The thermally stimulated current of each of the above samples was measured by a thermally stimulated current analyzer (TS-FETT) available from Rigaku Denki. Each sample was cooled to 93K at a rate of 5 K/min, and maintained at this temperature for 20 minutes. Then, light with $\lambda$max of 330 nm (using xenon lamp light passed through a band pass filter) was irradiated to the sample for 5 minutes, while applying a bias of 0.8V and maintaining at 93K. Then, temperature was raised up to 250K at a rate of 10 K/min, while applying a bias of 15 mV, and the current flowing at that time was measured.

Table 1

| Test No. | Dye | Pressure (Pa) | Temperature (°C) | Water content (mass%) | TSC (pA/cm$^2$) | Jsc (mA/cm$^2$) | Voc (V) | FF | $\eta_i$ (%) | SD | $\gamma$d (%) |
|---|---|---|---|---|---|---|---|---|---|---|---|
| 101 | 1 | $5 \times 10^4$ | Room temperature | 0.1 | 0.3 | 18.6 | 0.60 | 0.81 | 9.0 | 8 | 9 |
| 102 | 1 | 50 | Room temperature | 0.1 | 0.3 | 18.5 | 0.68 | 0.70 | 8.8 | 9 | 11 |
| 103 | 1 | Atmospheric pressure | 80 | 0.1 | 0.2 | 18.2 | 0.70 | 0.76 | 9.8 | 8 | 12 |
| 104 | 1 | Atmospheric pressure | 150 | 0.1 | 0.3 | 18.2 | 0.66 | 0.82 | 9.8 | 8 | 15 |
| 105 | 1 | Atmospheric pressure | Room temperature | 0.05 | 0.3 | 17.8 | 0.63 | 0.74 | 8.3 | 13 | 14 |
| 106 | 1 | 50 | 80 | 0.1 | 0.1 | 18.8 | 0.73 | 0.75 | 10.3 | 6 | 10 |
| 107 | 1 | 50 | Room temperature | 0.05 | 0.2 | 18.8 | 0.69 | 0.71 | 9.2 | 9 | 11 |
| 108 | 1 | 50 | 80 | 0.05 | 0.1 | 18.5 | 0.79 | 0.72 | 10.5 | 7 | 10 |
| C11 | 1 | Atmospheric pressure | Room temperature | 0.1 | 0.5 | 18.7 | 0.63 | 0.58 | 6.8 | 14 | 12 |

Table 2

| Test No. | Dye | Pressure (Pa) | Temperature (°C) | Water content (mass%) | TSC ($pA/cm^2$) | Jsc ($mA/cm^2$) | Voc (V) | FF | $\eta_i$ (%) | SD | $\gamma d$ (%) |
|---|---|---|---|---|---|---|---|---|---|---|---|
| 108 | 1 | 50 | 80 | 0.05 | 0.2 | 18.5 | 0.79 | 0.72 | 10.5 | 7 | 10 |
| C11 | 1 | Atmospheric pressure | Room temperature | 0.1 | 0.5 | 18.7 | 0.63 | 0.58 | 6.8 | 14 | 15 |
| 201 | 2 | 50 | 80 | 0.05 | 0.1 | 16.2 | 0.68 | 0.77 | 8.4 | 5 | 12 |
| C21 | 2 | Atmospheric pressure | Room temperature | 0.1 | 0.4 | 16.3 | 0.43 | 0.45 | 3.2 | 20 | 14 |
| 202 | 3 | 50 | 80 | 0.05 | 0.3 | 16.5 | 0.63 | 0.41 | 4.2 | 7 | 9 |
| C22 | 3 | Atmospheric pressure | Room temperature | 0.1 | 0.4 | 16.1 | 0.48 | 0.50 | 3.8 | 17 | 17 |
| 203 | 4 | 50 | 80 | 0.05 | 0.3 | 15.3 | 0.50 | 0.51 | 3.9 | 5 | 11 |
| C23 | 4 | Atmospheric pressure | Room temperature | 0.1 | 0.8 | 14.9 | 0.56 | 0.51 | 4.3 | 13 | 18 |

<Notations for descriptions in the tables>
Pressure: Pressure at the time of solvent removal treatment
Temperature: Temperature at the time of solvent removal treatment
Water content: Percentage content of water in dye-adsorbing liquid
TCS: TCS current value

It can be seen that, as compared with the Comparative examples, all of the Examples have relatively superior detailed cell performances, such as Jsc, Voc, and FF, consequently obtain higher conversion efficiency, have smaller fluctuations in the efficiency, and have smaller drop rates of conversion efficiency of the cells after the lapse of time period in the dark at a high temperature. In particular, it can be seen that the differences are noticeable, by making a comparison between the results of the identical dye employed (Table 2). It is understood that one of the factors is the small TSC current value. From these results, it is understood that, as a result of the production method of the present application, the number of trap levels has decreased, and as a result, the TSC current is decreased, and along with this, an improvement in the cell performance, a lowering in the fluctuation, and an enhancement in the durability are achieved.

Dye 1

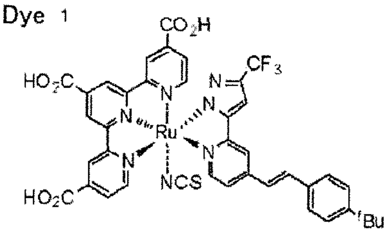

Dye 3

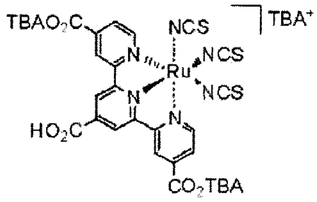

Black Dye

Dye 2

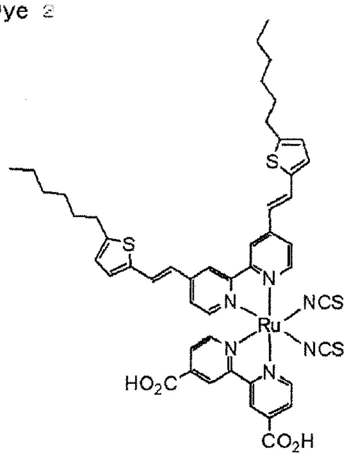

Dye 4

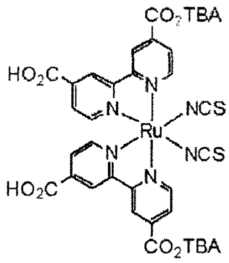

(Reference comparative example: comparison with other dyes)

In order to make a comparison with other dyes, dyes 1 to 4 were replaced with the dyes described below at the level of Test 108, to eliminate the fluctuation, and the test was carried out in the same manner as above. However, the effects of the present invention were not significantly exhibited.

Dye 5

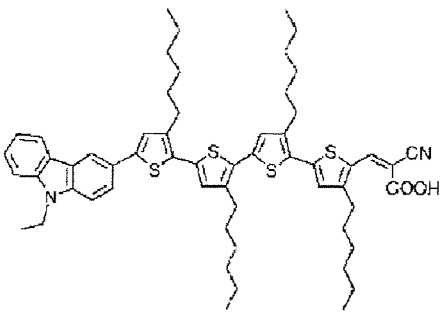

Dye 6

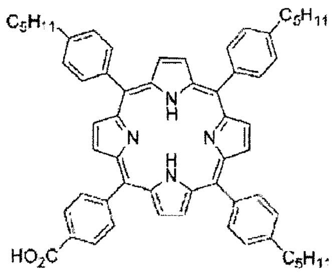

Dye 7

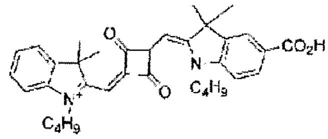

(Example 2)

As was confirmed in the above Example 1, with respect to an improvement owing to the production process of the present invention, excellent effects can be exhibited in the dye represented by formula (I) or formula (II), which can give particularly high conversion efficiency. The reason is not clearly understood, but the dye has an influence on enhancement of the characteristics, including the TSC current, and exhibits a marked enhancement particularly on the fill factor (FF) and the increase rate of the conversion efficiency ($\eta_i$). Then, in order to verify this, the evaluations were carried out in the same manner as above, by employing other kinds of the dyes. In the results given below, Tests 301 to 304 are summaries of the same experiments results as in the above Tests 108, 201, 202, and 203.

Table 3

| Test No. | Dye | $\eta_i$ % | Hi improvement % | FF improvement % |
|---|---|---|---|---|
| 301 | 1 | 10.5 | 1.5 | 1.2 |
| 302 | 2 | 8.4 | 2.6 | 1.7 |
| 303 | 3 | 4.2 | 1.1 | 0.8 |
| 304 | 4 | 3.2 | 0.9 | 1 |
| 305 | (II-1) | 10.3 | 1.8 | 1.4 |
| 306 | (II-5) | 9.4 | 1.3 | 1.4 |
| 307 | (II-7) | 10.7 | 2.1 | 1.2 |
| 308 | Compound 4 | 8.3 | 2.4 | 1.4 |
| 309 | Compound 7 | 9.4 | 2.6 | 1.7 |

• $\eta_i$: Photoelectric conversion efficiency when the treatment was carried out at a pressure 50 Pa, a temperature 80°C, and a water content 0.05 mass%
• $\eta_i$ improvement ratio: Ratio ($\eta_i1/\eta_i2$) of the photoelectric conversion efficiency ($\eta_i1$) when the treatment was carried out at a pressure of 50 Pa, a temperature 80°C, and a water content 0.05 mass%, to the photoelectric conversion efficiency ($\eta_i2$) when the treatment was carried out at room temperature and atmospheric pressure, and a water content of 0.1 mass%
• FF improvement ratio: Ratio (FF1/FF2) of the fill factor (FF1) when the treatment as carried out at a pressure 50 Pa, a temperature 80°C, and a water content 0.05 mass%, to the fill factor (FF2) when the treatment was carried out at room temperature and atmospheric pressure, and a water content 0.1 mass%

The dye structures in Tests 305 to 309 are described in this text.
Having described my invention as related to the present embodiments, it is my intention that the invention not be limited by any of the details of the description, unless otherwise specified, but rather be construed broadly within its spirit and scope as set out in the accompanying claims.
This application claims priority on Patent Application No. 2012-025146 filed in Japan on February 8, 2012, which is entirely herein incorporated by reference.

REFERENCE SIGNS LIST

1 Electrically-conductive support

- 2 Photoconductor layer
- 21 Metal complex dye
- 22 Semiconductor fine-particle
- 3 Electrolyte layer
- 4 Counter electrode
- 5 Light-receiving electrode
- 6 Circuit
- 10 Photoelectric conversion element
- 100 System utilizing the dye-sensitized solar cell

## Claims

**1.** A method of producing a photoelectric conversion element, the photoelectric conversion element having:

an electrically-conductive support having a substrate and a transparent electrode;
a photoconductor layer having: a metal complex sensitizing dye having an adsorbing group; and semiconductor fine-particles;
an electrolyte layer having an electrolyte; and
a counter electrode,
wherein, when a dye-adsorbing liquid containing the sensitizing dye in a solvent is brought into contact with the semiconductor fine-particles, to form a dye-adsorbed electrode having the sensitizing dye adsorbed on the semiconductor fine-particles, a treatment is carried out at least under any one of conditions A, B, and C:

[A: In solvent drying after dye adsorption, a heat treatment is carried out at a temperature of 50 to 200°C.]
[B: In solvent drying after dye adsorption, drying is carried out at a pressure of 50,000 to $10^{-3}$ Pa.]
[C: The sensitizing dye is contained in the dye-adsorbing liquid in an amount of 0.001 to 0.1% by mass, and the amount of water is kept below 0.1% by mass.].

**2.** The method of producing a photoelectric conversion element according to claim 1, wherein the conditions A and C are applied to in combination, the conditions B and C are applied to in combination, or the conditions A, B, and C are applied to in combination.

**3.** The method of producing a photoelectric conversion element according to claim 1 or 2, wherein the solvent drying time period for the conditions A and B is set to 5 to 30 minutes.

**4.** The method of producing a photoelectric conversion element according to any one of claims 1 to 3, wherein the solvent of the dye-adsorbing liquid is an organic solvent selected from the group consisting of an aliphatic alcohol having 1 to 6 carbon atoms in total, an aliphatic amide having 2 to 6 carbon atoms in total, and a combination thereof.

**5.** The method of producing a photoelectric conversion element according to any one of claims 1 to 4, wherein the sensitizing dye contains at least a dye represented by formula (I):

$$ML^1_{m1}L^2_{m2}X_{mX}\cdot CI \qquad (I)$$

wherein, in formula (I), M represents a metal atom; $L^1$ represents a ligand represented by formula (L1); $L^2$ represents a ligand represented by formula (L2); X represents a monodentate ligand; m1 is 1 or 2; m2 is an integer of 0 or 1; mX is an integer of 0 to 3; and CI represents a counter ion in the case where the counter ion is necessary to neutralize a charge in formula (I);

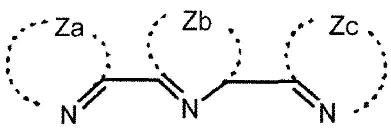

: (L1)

wherein, in formula (L1), Za, Zb, and Zc each independently represent a group of atoms for forming a 5- or 6-membered ring; and at least one ring formed by Za, Zb, or Zc has an acidic group;

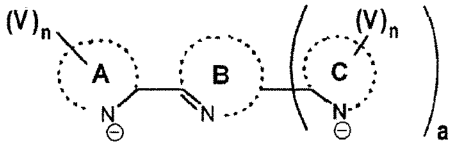

: (L2)

wherein, in formula (L2), A, B and C each independently represent a nitrogen-containing aromatic ring having a 5-membered or higher-membered ring; a is 0 or 1; V represents a substituent; and n represents an integer of 0 or more.

**6.** The method of producing a photoelectric conversion element according to any one of claims 1 to 4, wherein the sensitizing dye contains at least a dye represented by formula (II):

$$ML^3_{m3}L^4_{m4}Y_{mY}\cdot CI \qquad (II)$$

wherein, in formula (II), M represents a metal atom; $L^3$ represents a bidentate ligand represented by formula (L3); $L^4$ represents a bidentate or terdentate ligand represented by formula (L4); Y represents a monodentate or bidentate ligand; m3 represents an integer of 0 to 3; m4 represents an integer of 1 to 3; mY represents an integer of 0 to 2; and CI represents a counter ion in the case where the counter ion is necessary to neutralize a charge in formula (II);

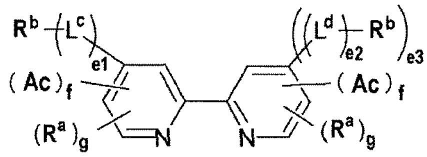

: (L3)

wherein, in formula (L3), Ac represents an acidic group; $R^a$ represents a substituent; $R^b$ represents an alkyl group or an aromatic cyclic group; e1 and e2 each independently represent an integer of 0 to5; $L^c$ and $L^d$ each independently represent a conjugated chain; e3 is 0 or 1; f represents an integer of 0 to 3; g represents an integer of 0 to 3; and

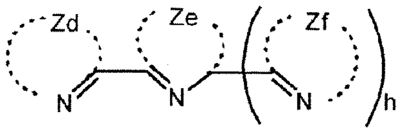

: (L4)

wherein, in formula (L4), Zd, Ze, and Zf each independently represent a group of atoms for forming a 5- or 6-membered ring; h is 0 or 1; and at least one ring formed by Zd, Ze, or Zf has an acidic group.

**7.** The method of producing a photoelectric conversion element according to claim 5 or 6, wherein M in the sensitizing dye is Ru, Fe, Os, Cu, W, Cr, Mo, Ni, Pd, Pt, Co, Ir, Rh, Re, Mn, or Zn.

**8.** A photoelectric conversion element, having:

an electrically-conductive support having a substrate and a transparent electrode,
a photoconductor layer having: a metal complex sensitizing dye having an adsorbing group; and semiconductor fine-particles,
an electrolyte layer having an electrolyte, and
a counter electrode,
wherein a dye-adsorbed electrode has no peak current value at 150K or more, in measurement of a thermally-stimulated current; and
wherein the peak electric current value at 100 to 120K is 0.3 $pA/cm^2$ or less.

**9.** The photoelectric conversion element according to claim 8, wherein a redox agent constituting the electrolyte is a cobalt complex.

**10.** The photoelectric conversion element according to claim 8 or 9, wherein the sensitizing dye contains at least a dye represented by formula (I):

$$ML^1_{m1}L^2_{m2}X_{mX}\cdot CI \qquad (I)$$

wherein, in formula (I), M represents a metal atom; $L^1$ represents a ligand represented by formula (L1); $L^2$ represents a ligand represented by formula (L2); X represents a monodentate ligand; m1 is 1 or 2; m2 is an integer of 0 or 1; mX is an integer of 0 to 3; and CI represents a counter ion in the case where the counter ion is necessary to neutralize a charge in formula (I);

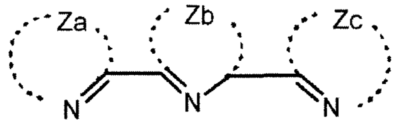

: (L1)

wherein, in formula (L1), Za, Zb, and Zc each independently represent a group of atoms for forming a 5- or 6-membered ring; and at least one ring formed by Za, Zb, or Zc has an acidic group; and

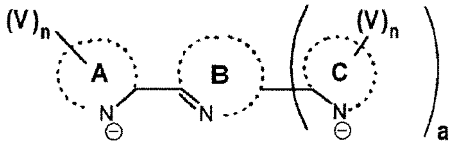

: (L2)

wherein, in formula (L2), A, B and C each independently represent a nitrogen-containing aromatic ring having a 5-membered or higher-membered ring; a represents 0 or 1; V represents a substituent; and n represents an integer of 0 or more.

**11.** The photoelectric conversion element according to claim 8 or 9, wherein the sensitizing dye contains at least a dye represented by formula (II):

$$ML^3_{m3}L^4_{m4}Y_{mY}\cdot CI \qquad (II)$$

wherein, in formula (II), M represents a metal atom; $L^3$ represents a bidentate ligand represented by formula (L3); $L^4$ represents a bidentate or terdentate ligand represented by formula (L4); Y represents a monodentate or bidentate ligand; m3 represents an integer of 0 to 3; m4 represents an integer of 1 to 3; mY represents an integer of 0 to 2; and CI represents a counter ion in the case where the counter ion is necessary to neutralize a charge in formula (II);

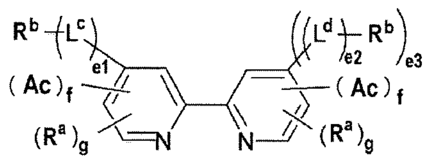

: (L3)

wherein, in formula (L3), Ac represents an acidic group; $R^a$ represents a substituent; $R^b$ represents an alkyl group or an aromatic cyclic group; e1 and e2 each independently represent an integer of 0 to 5; $L^c$ and $L^d$ each independently represent a conjugated chain; e3 represents 0 or 1; f represents an integer of 0 to 3; and g represents an integer of 0 to 3; and

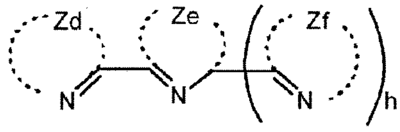

: (L4)

wherein, in formula (L4), Zd, Ze, and Zf each independently represent a group of atoms capable of forming a 5- or

6-membered ring; h represents 0 or 1; and at least one ring formed by Zd, Ze, or Zf has an acidic group.

**12.** A dye-sensitized solar cell, comprising the photoelectric conversion element according to any one of claims 8 to 11.

{Fig. 1}

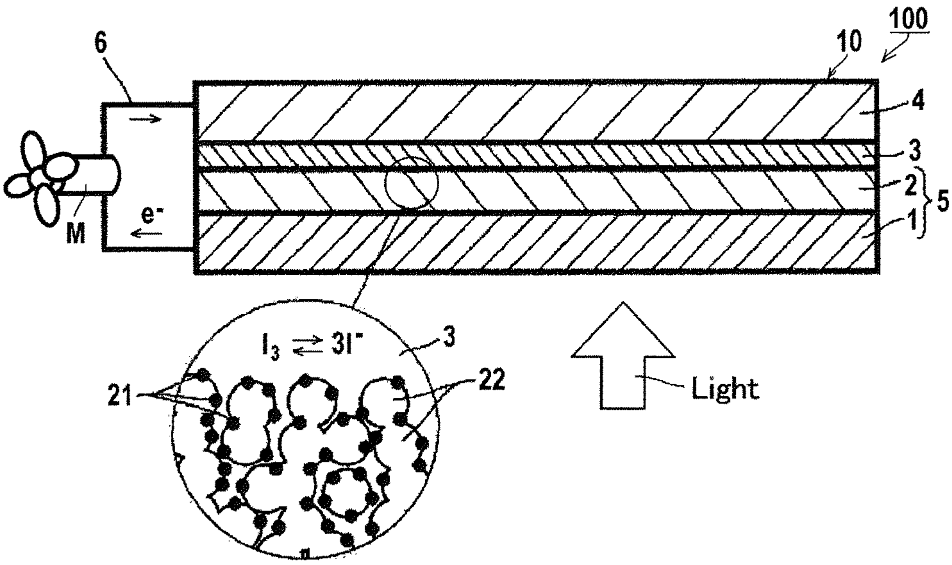


{Fig. 2}

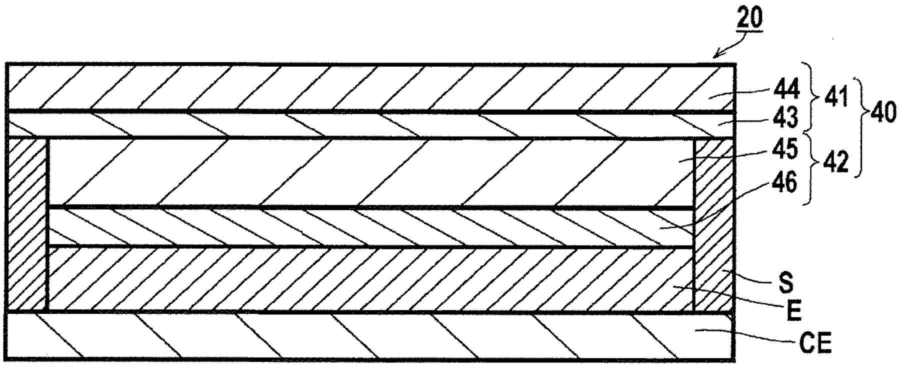

## INTERNATIONAL SEARCH REPORT

International application No.
PCT/JP2013/052584

A. CLASSIFICATION OF SUBJECT MATTER
*H01M14/00*(2006.01)i, *C09B57/10*(2006.01)i, *H01L31/04*(2006.01)i, *C07F15/00* (2006.01)n

According to International Patent Classification (IPC) or to both national classification and IPC

B. FIELDS SEARCHED

Minimum documentation searched (classification system followed by classification symbols)
H01M14/00, C09B57/10, H01L31/04, C07F15/00

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2013 |
| Kokai Jitsuyo Shinan Koho | 1971-2013 | Toroku Jitsuyo Shinan Koho | 1994-2013 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | JP 2005-251591 A (Toyo Seikan Kaisha, Ltd.), 15 September 2005 (15.09.2005), entire text; all drawings (Family: none) | 1,3-4<br>1-12 |
| Y | JP 2006-279018 A (Seiko Epson Corp.), 12 October 2006 (12.10.2006), paragraphs [0060] to [0062] & JP 2011-54572 A & US 2006/0160265 A1 | 1-12 |
| Y | JP 11-102734 A (Sharp Corp.), 13 April 1999 (13.04.1999), paragraph [0006] (Family: none) | 1-12 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 26 February, 2013 (26.02.13) | 05 March, 2013 (05.03.13) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No. PCT/JP2013/052584

C (Continuation). DOCUMENTS CONSIDERED TO BE RELEVANT

| Category* | Citation of document, with indication, where appropriate, of the relevant passages | Relevant to claim No. |
|---|---|---|
| Y | WO 2006/123785 A1 (Nippoh Chemicals Co., Ltd.), 23 November 2006 (23.11.2006), paragraph [0078] & JP 4982361 B | 1-12 |
| Y | US 2010/0258175 A1 (Yun Chi, Kellen Chen, Yi-Huan Hong, Pi-Tai Chou, Bo-So Chen, Hui-Chu Hsu), 14 October 2010 (14.10.2010), paragraph [0020] & TW 201036983 A | 5,7-10,12 |
| Y | JP 2012-12570 A (Fujifilm Corp.), 19 January 2012 (19.01.2012), paragraphs [0092], [0154] & WO 2011/152318 A1 & TW 201218482 A | 6-9,11-12 |
| Y | JP 2006-318771 A (Japan Carlit Co., Ltd.), 24 November 2006 (24.11.2006), paragraph [0028] (Family: none) | 9 |
| A | JP 2012-003955 A (Sony Corp.), 05 January 2012 (05.01.2012), paragraphs [0041] to [0046] (Family: none) | 1-2 |
| A | JP 2004-319872 A (TDK Corp.), 11 November 2004 (11.11.2004), paragraphs [0064] to [0066], [0070] to [0073] (Family: none) | 1-2 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*


### Patent documents cited in the description

- JP 4576494 B
- JP 2001291534 A
- JP 2010135184 A
- JP 2009132922 A
- JP 2008311127 A
- US 20100258175 A1
- US 4927721 A
- US 4684537 A
- US 5084365 A
- US 5350644 A
- US 5463057 A
- US 5525440 A
- JP 7249790 A
- JP 2004220974 A
- JP 2008135197 A
- WO 9518456 A
- JP 8259543 A
- JP 2005135902 A
- JP 2001160425 A
- JP 2003123859 A
- JP 2002260746 A
- JP 4260494 B
- JP 2004146425 A
- JP 2000340269 A
- JP 2002289274 A
- JP 2004152613 A
- JP 9027352 A
- JP 2000090989 A
- JP 2003217688 A
- JP 2002367686 A
- JP 2003323818 A
- JP 2001043907 A
- JP 2005085500 A
- JP 2004273272 A
- JP 2000323190 A
- JP 2000 A
- JP 228234 A
- JP 2001266963 A
- JP 2001185244 A
- JP 2001525108 T
- JP 2001203377 A
- JP 2000100483 A
- JP 2001210390 A
- JP 2002280587 A
- JP 2001273937 A
- JP 2000285977 A
- JP 2001320068 A
- JP 2010218770 A
- JP 2012025146 A

### Non-patent literature cited in the description

- *Japanese Journal of Applied Physics,* 2008, vol. 47 (1), 505
- Lange's Handbook of Chemistry. McGraw-Hill, 1979
- Kagaku No Ryoiki. Nankodo, 1979, vol. 122, 96-103
- *Chemical Reviews,* 1991, vol. 91, 165-195
- **CORWIN HANSCH ; A. LEO ; R. W. TAFT.** A Survey of Hammett Substituent Cosntants and Resonance and Field Parameters. *Chem. Rev.,* 1991, vol. 91, 165-195
- *Chem. Commun.,* 2009, 5844-5846
- *Denki Kagaku,* 1997, vol. 65 (11), 923
- *Japanese Journal of Applied Physics,* 2008, vol. 47, 505